(19) Europäisches Patentamt
European Patent Office
Office européen des brevets

(11) **EP 4 350 399 A1**

(12) **EUROPEAN PATENT APPLICATION**
published in accordance with Art. 153(4) EPC

(43) Date of publication:
**10.04.2024 Bulletin 2024/15**

(21) Application number: **22845709.9**

(22) Date of filing: **10.06.2022**

(51) International Patent Classification (IPC):
*G02B 5/20* (2006.01)      *G02B 3/00* (2006.01)
*G09F 9/30* (2006.01)       *G09F 9/302* (2006.01)
*H01L 27/146* (2006.01)     *H10K 59/00* (2023.01)
*H10K 50/00* (2023.01)

(52) Cooperative Patent Classification (CPC):
**G02B 3/00; G02B 5/20; G09F 9/30; G09F 9/302;
H01L 27/146; H05B 33/02; H05B 33/12**

(86) International application number:
**PCT/JP2022/023503**

(87) International publication number:
**WO 2023/002773 (26.01.2023 Gazette 2023/04)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **19.07.2021 JP 2021119008**

(71) Applicant: **Canon Kabushiki Kaisha
Tokyo 146-8501 (JP)**

(72) Inventors:
• **HINATA, Shoma
Tokyo 146-8501 (JP)**

• **ISHIZUYA, Koji
Tokyo 146-8501 (JP)**
• **TAKAHASHI, Tetsuo
Tokyo 146-8501 (JP)**
• **MATSUDA, Yojiro
Tokyo 146-8501 (JP)**
• **OKITA, Akira
Tokyo 146-8501 (JP)**

(74) Representative: **WESER & Kollegen
Patentanwälte PartmbB
Radeckestraße 43
81245 München (DE)**

(54) **DISPLAY DEVICE, IMAGING DEVICE, AND ELECTRONIC APPARATUS**

(57)    A display device includes a light-emitting element array including a plurality of light-emitting elements arranged on a substrate, and a color filter layer, on the light-emitting element array, including a plurality of first bandpass filters configured to transmit light in a first band, a plurality of second bandpass filters configured to transmit light in a second band different from the first band, and a plurality of third bandpass filters configured to transmit light in a third band different from the first band and the second band, wherein the color filter layer has an arrangement including at least a first column in which the first bandpass filters are arranged, a second column in which the second bandpass filters and the third bandpass filters are alternately arranged, and a third column in which the second bandpass filters and the third bandpass filters are alternately arranged in an order different from the second column, and at least one first bandpass filter is in contact with at least one second bandpass filter and at least one third bandpass filter.

F I G. 1A

**(Cont. next page)**

EP 4 350 399 A1

F I G. 1B

MLL

PU ML2 ML2

GSP

BSP

RSP

ML2 ML1 ML2

F I G. 1C

PU

CFG,
GSP

CFB,
BSP

BM

CFR,
RSP

## Description

TECHNICAL FIELD

The present invention relates to a display device, an image sensing device, and an electronic apparatus.

BACKGROUND ART

As typical examples of a display device, a liquid crystal display device and an organic EL display device are known. As the advantages of the organic EL display device, the degree of freedom of shape is high, and the panel is thin and lightweight. Organic EL display devices include a coating type that causes subpixels to generate light components of different colors and a white type that causes subpixels to generate white light and spectrally separates the light using color filters. The coating type has an advantage that power consumption is small but has a disadvantage that a higher resolution can hardly be implemented because it is manufactured using a metal mask. The white type has a disadvantage that power consumption is large because colors are expressed using color filters but has an advantage that a higher resolution can easily be implemented because the pixel pitch can be reduced by photolithography.

To compensate for the disadvantage that a higher resolution is difficult to obtain in the coating type, a technique of arranging subpixels in accordance with a pentile arrangement has come out. A traditional pentile arrangement uses a human characteristic sensitive to green, and red and blue subpixels are arranged at a low density, thereby implementing a high resolution in a pseudo manner. Since the pentile arrangement can implement a resolution higher than the real resolution in a pseudo manner, an auxiliary effect of decreasing the number of data lines is also provided. A display device using the pentile arrangement is described in PTL 1.

CITATION LIST

PATENT LITERATURE

PTL 1: Japanese Patent Laid-Open No. 2020-205260

SUMMARY OF INVENTION

TECHNICAL PROBLEM

According to one aspect of the present invention, there is provided a display device comprising a light-emitting element array including a plurality of light-emitting elements arranged on a substrate, and a color filter layer, on the light-emitting element array, including a plurality of first bandpass filters configured to transmit light in a first band, a plurality of second bandpass filters configured to transmit light in a second band different from the first band, and a plurality of third bandpass filters configured to transmit light in a third band different from the first band and the second band, wherein the color filter layer has an arrangement including at least a first column in which the first bandpass filters are arranged, a second column in which the second bandpass filters and the third bandpass filters are alternately arranged, and a third column in which the second bandpass filters and the third bandpass filters are alternately arranged in an order different from the second column, and at least one first bandpass filter is in contact with at least one second bandpass filter and at least one third bandpass filter.

According to another aspect of the present invention, there is provided a display device comprising a light-emitting element array including a plurality of light-emitting elements arranged on a substrate, and a color filter layer arranged on the light-emitting element array and including a plurality of first bandpass filters configured to transmit light in a first band, a plurality of second bandpass filters configured to transmit light in a second band different from the first band, and a plurality of third bandpass filters configured to transmit light in a third band different from the first band and the second band, wherein the color filter layer has an arrangement in which the first bandpass filters are arranged in accordance with a delta arrangement, and the number of second bandpass filters and third bandpass filters is smaller than the number of first bandpass filters, and at least one first bandpass filter is in contact with at least one second bandpass filter and at least one third bandpass filter.

BRIEF DESCRIPTION OF DRAWINGS

Fig. 1A is a view showing the configuration of a display device according to the first embodiment;

Fig. 1B is a view showing the configuration of the display device according to the first embodiment;

Fig. 1C is a view showing the configuration of the display device according to the first embodiment;

Fig. 2 is a view showing the configuration of the display device according to the first embodiment;

Fig. 3 is a view showing the configuration of the display device according to the first embodiment;

Fig. 4 is a view showing the configuration of a modification of the display device according to the first embodiment;

Fig. 5A is a view for explaining reduction of color mixing by providing a microlens array;

Fig. 5B is a view for explaining reduction of color mixing by providing a microlens array;

Fig. 6A is a view showing the configuration of a display device according to the second embodiment;

Fig. 6B is a view showing the configuration of the display device according to the second embodiment;

Fig. 7 is a view showing the configuration of a display device according to the third embodiment;

Fig. 8A is a view showing the configuration of a display device according to the fourth embodiment;

Fig. 8B is a view showing the configuration of the display device according to the fourth embodiment;

Fig. 9A is a view showing the configuration of a display device according to the fifth embodiment;

Fig. 9B is a view showing the configuration of the display device according to the fifth embodiment;

Fig. 10 is a view showing the configuration of the display device according to the fifth embodiment;

Fig. 11 is a view showing the configuration of a display device according to the sixth embodiment;

Fig. 12A is a view showing the configuration of a display device according to the seventh embodiment;

Fig. 12B is a view showing the configuration of the display device according to the seventh embodiment;

Fig. 13 is a view showing the configuration of a display device according to the eighth embodiment;

Fig. 14 is a view showing the configuration of a display device according to the ninth embodiment;

Fig. 15 is a view showing the configuration of a display device according to the 10th embodiment;

Fig. 16 is a view for explaining a technique applicable to the first to 10th embodiments;

Fig. 17 is a view for explaining a technique applicable to the first to 10th embodiments;

Fig. 18 is a view for explaining a technique applicable to the first to 10th embodiments;

Fig. 19 is a view for explaining an application example;

Fig. 20 is a view for explaining an application example;

Fig. 21A is a view for explaining an application example;

Fig. 21B is a view for explaining an application example;

Fig. 22A is a view for explaining an application example; and

Fig. 22B is a view for explaining an application example.

DESCRIPTION OF EMBODIMENTS

Hereinafter, embodiments will be described in detail with reference to the attached drawings. Note, the following embodiments are not intended to limit the scope of the claimed invention. Multiple features are described in the embodiments, but limitation is not made to an invention that requires all such features, and multiple such features may be combined as appropriate. Furthermore, in the attached drawings, the same reference numerals are given to the same or similar configurations, and redundant description thereof is omitted.

In this specification, a shape explained as a square, a hexagon, an octagon, or the like is an expression that permits a manufacturing error, and can include, for example, a shape with a round corner. For example, a shape expressed as a polygon such as a square, a hexagon, or an octagon can include a figure which is inscribed in a strict polygon in a mathematical expression and whose area difference from the strict polygon is less than 20%, 15%, 10%, or 5%.

In the attached drawings, constituent elements with the same pattern indicate constituent elements having the same feature and characteristic. For example, color filters (bandpass filters) with the same pattern are color filters (bandpass filters) that transmit light in the same band, in other words, color filters of the same color.

As described above, the pentile arrangement is an arrangement used to overcome a disadvantage in a coating type organic EL display device. The present inventors examined applying this to a color filter layer in the white type. The color filter layer can be formed at a high density (high resolution) by applying lithography. In the white type, a light-emitting element array can be formed at a high density (high resolution) using lithography. Hence, when the pentile arrangement is applied to a color filter layer in a white type display device, a resolution higher than a real resolution determined by the number of data lines can be implemented in a pseudo manner.

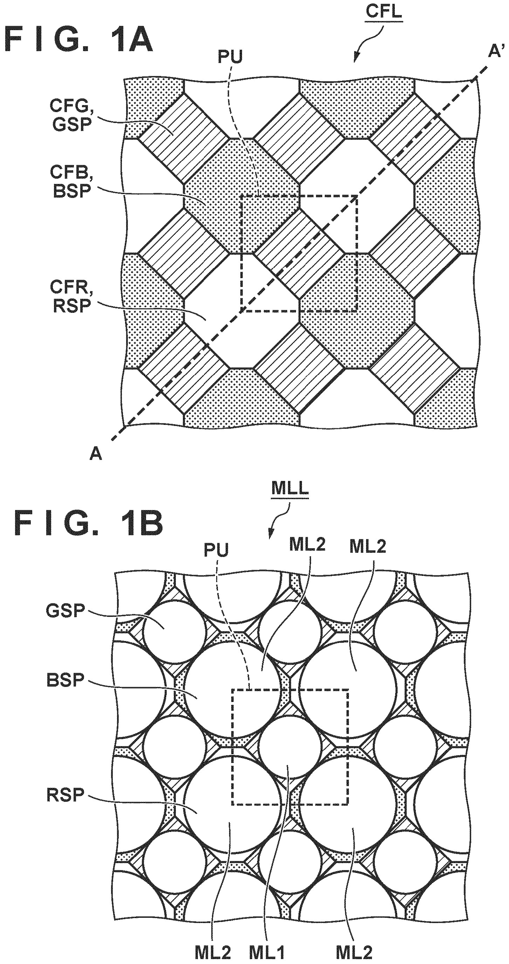

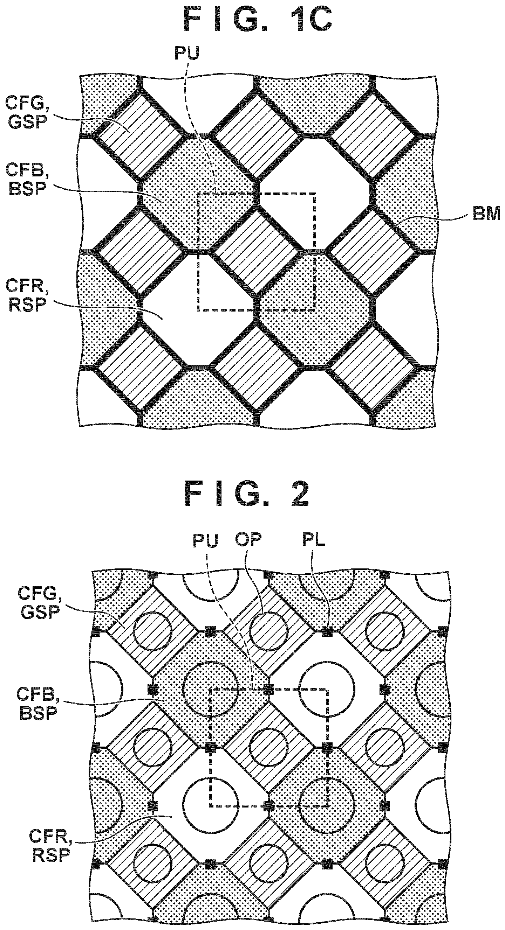

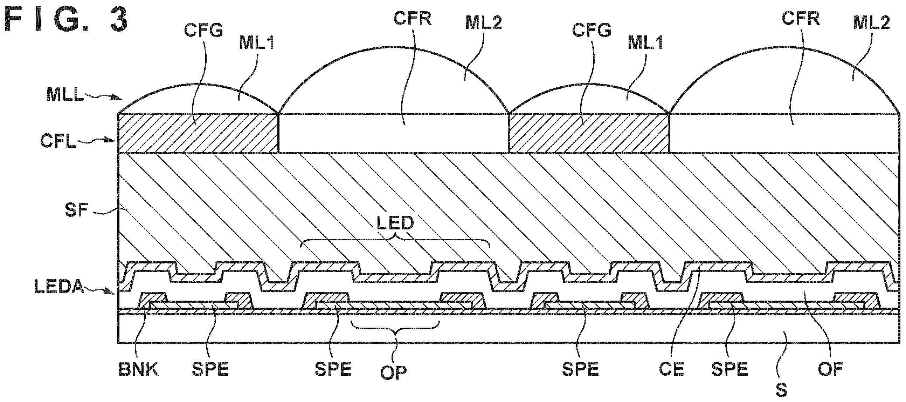

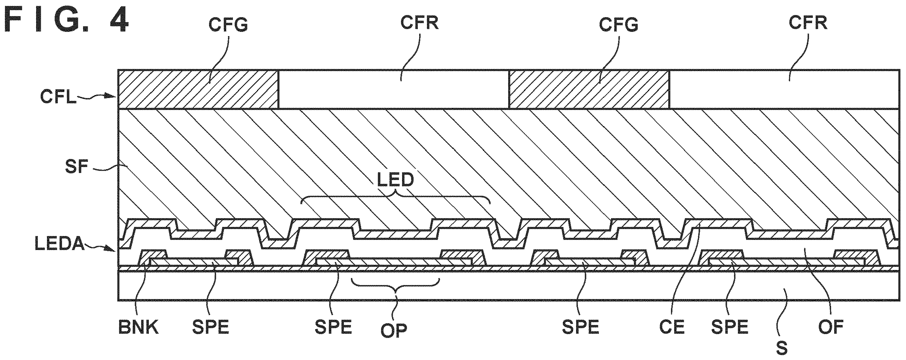

Fig. 1A is a plan view of a color filter layer CFL of a display device according to the first embodiment, and Fig. 1B is a plan view of a microlens layer MLL of the display device according to the first embodiment. The shape of each lens portion of the microlens layer MLL in a planar view may be an inscribed circle of the shape of the color filter layer CFL in the planar view. A lens portion of the microlens layer MLL indicates a portion forming a concave portion or a convex portion for an organic EL display device and is a portion contributing to light condensation. Fig. 2 shows openings OP provided in a bank BNK of the display device according to the first embodiment. The opening OP may be circular in the planar view. If a microlens is provided, the ratio of the area of the opening OP to the area of the microlens in the planar view may be 10% to 50%, and preferably 20% to 40%. In other words, the ratio between the area of the microlens and the area of the opening OP in the planar view may be 0.32 to 0.71 : 1, preferably 0.45 to 0.63 : 1. The opening OP may have a polygonal shape conforming to the shape of a color filter in the planar view. More specifically, the opening OP may have a rectangular shape to an octagonal shape. Fig. 3 is a sectional view of the display device according to the first embodiment. Fig. 3 corresponds to a cross section taken along a line A - A' in Fig. 1A. Fig. 4 is a sectional view showing a modification of the display device according to the first embodiment. Fig. 4 corresponds to a cross section taken along a line A - A' in Fig. 1A. The modification of the display device according to the first embodiment does not include a microlens layer.

The display device according to the first embodiment includes a light-emitting element array LEDA including a plurality of light-emitting elements LED arranged on a substrate S, and the color filter layer CFL including a plurality of color filters arranged on the light-emitting element array LEDA in accordance with the pentile arrangement. The light-emitting elements LED generate white light. In another viewpoint, the light-emitting elements LED generate light components including wavelengths of red, green, and blue. For the light-emitting elements configured to generate white light, the distance between pixels can be decreased because of the manufacturing step. The distance between the pixels may be the length of one side of a unit pixel region PU in Figs. 1A and 1B. More specifically, the distance between the pixels may be 12 $\mu$m or less, 10 $\mu$m or less, or 8 $\mu$m or less. The plurality of color filters of the color filter layer CFL can include a plurality of first bandpass filters, a plurality of second bandpass filters, and a plurality of third bandpass filters. The first bandpass filter is a color filter that transmits light in a first band. The second bandpass filter is a color filter that transmits light in a second band different from the first band. The third bandpass filter is a color filter that transmits light in a third band different from the second band and the first band. In this specification, the pentile arrangement is an arrangement including a first column, a second column, and a third column. The first column is a column in which the first bandpass filters are arranged. The second column is a column in which the second bandpass filters and the plurality of third bandpass filters are alternately arranged. The third column is a column in which the second bandpass filters and the third bandpass filters are alternately arranged in an order different from the second column. The first column may be arranged between the second column and the third column in a row direction. The row direction is a direction orthogonal to a direction in which the first bandpass filters are arranged in the first column. Here, at least one first bandpass filter is in contact with at least one second bandpass filter and at least one third bandpass filter. That is, the second bandpass filters in the second column are adjacent to the third bandpass filters in the third column. Depending on the sizes of the bandpass filters, the first bandpass filters, the second bandpass filters, and the third bandpass filters can be in contact with each other. Here, "contact" may include not only a case where the bandpass filters are in direct contact with each other but also a case where the bandpass filters are in indirect contact while superposing a light absorption layer or the like therebetween.

In the first embodiment, the first bandpass filter is a bandpass filter CFG that transmits green (G) light, the second bandpass filter is a bandpass filter CFR that transmits red (R) light, and the third bandpass filter is a bandpass filter CFB that transmits blue (B) light. However, these may be replaced with each other.

Here, areas occupied, in the unit pixel region PU, by the bandpass filters with the largest number of pieces, the bandpass filters with the second largest number of pieces, and the bandpass filters with the third largest number of pieces among the first bandpass filters, the second bandpass filters, and the third bandpass filters are defined as A, B, and C, respectively. Here, if, among the first, second, and third bandpass filters, two types of bandpass filters have the largest number of pieces, the area occupied by one type of bandpass filters in the unit pixel region PU is defined as A, and the area occupied by the other type in the unit pixel region PU is defined as B. The numbers of first, second, and third bandpass filters may equal. In this case, the area occupied by one type of bandpass filters in the unit pixel region PU is defined as A, the area occupied by another type in the unit pixel region PU is defined as B, and the area occupied by still another type in the unit pixel region PU is defined as C.

Under the above-described conditions, it is preferable that A/B < 2·C/B is satisfied, it is more preferable that A/B < 1.5·C/B is satisfied, and it is most preferable that A/B < 1.2·C/B is satisfied. Alternatively, B and C may have a value less than ±5% of A.

The bandpass filters with the largest number of pieces among the first bandpass filters, the second bandpass filters, and the third bandpass filters can be defined as main bandpass filters. A region surrounded by perpendicular bisectors between one main bandpass filter and respective main bandpass filters around the one main bandpass filter can be defined as the unit pixel region PU including the one main bandpass filter.

Here, total areas occupied, in the light-emitting element array LEDA, by the bandpass filters with the largest number of pieces, the bandpass filters with the second largest number of pieces, and the bandpass filters with the third largest number of pieces among the first bandpass filters, the second bandpass filters, and the third bandpass filters are defined as TA, TB, and TC, respectively. Here, if, among the first, second, and third bandpass filters, two types of bandpass filters have the largest number of pieces, the total area occupied by one type of bandpass filters in the light-emitting element array LEDA is defined as TA, and the area occupied by the other type in the light-emitting element array LEDA is defined as B. If the numbers of first, second, and third bandpass filters equal, the total area of one type is defined as A, the total area of another type is defined as B, and the total area of still another type is defined as C.

Under the above-described conditions, it is preferable that TA/TB ≦ 2·TC/TB is satisfied, it is more preferable that TA/TB < 1.5·TC/TB is satisfied, and it is most preferable that TA/TB < 1.2·TC/TB is satisfied. TB and TC may have a value less than ±5% of TA.

In the example shown in Figs. 1A and 1B, the areas A : B : C occupied by the first bandpass filters (CFG), the second bandpass filters (CFR), and the third bandpass filters (CFB) in the unit pixel region PU satisfy 1 : 1 : 1. Hence, A/B = CB = 1. Also, in the example shown in Figs. 1A and 1B, the total areas TA : TB : TC occupied by the first bandpass filters (CFG), the second bandpass filters (CFR), and the third bandpass filters (CFB) in the light-emitting element array LEDA satisfy 1 : 1 : 1. Hence, TA/TB = TC/TB = 1.

In the example shown in Figs. 1A and 1B, the area occupied by the first bandpass filters, that is, the bandpass filters (CFG) that transmit green light in the unit pixel region PU equals the area occupied by the second bandpass filters, that is, the bandpass filters (CFR) that transmit red light in the unit pixel region PU. Also, in the example shown in Figs. 1A and 1B, the area occupied by the first bandpass filters, that is, the bandpass filters (CFG) that transmit green light in the unit pixel region PU equals the area occupied by the third bandpass filters, that is, the bandpass filters (CFB) that transmit blue light in the unit pixel region PU. This is advantageous in reducing color mixing from the green subpixels to the red and blue subpixels, as compared to a case where the area of the green subpixels is larger.

The plurality of first bandpass filters (CFG in the first embodiment) each have a square shape and are arranged apart from each other in a square grating pattern. The plurality of second bandpass filters (CFR in the first embodiment) and the plurality of third bandpass filters (CFB in the first embodiment) each have an octagonal shape formed by four sets of parallel opposite sides. Two second bandpass filters (CFR) are in line contact with one set of opposite sides of the square of the first bandpass filter (CFG), and two third bandpass filters (CFB) are in line contact with the other set of opposite sides of the square of the first bandpass filter (CFG). Two sets of opposite sides among the four sets of opposite sides of the second bandpass filter (CFR), which are not in contact with the first bandpass filters (CFG), are in line contact with two sets of opposite sides among the four sets of opposite sides of the third bandpass filters (CFB), which are not in contact with the first bandpass filters (CFG).

Here, for the purpose of reducing color mixing, light absorption layers may be provided between the bandpass filters, and the bandpass filters may be in line contact via the light absorption layers. Fig. 1C shows an example of a plan view of the color filter layer CFL in a case where light absorption layers are provided between the bandpass filters. The first bandpass filter (CFG) and two second bandpass filters (CFR), and the first bandpass filter (CFG) and two third bandpass filters (CFB) are in line contact via light absorption layers BM. Two sets of opposite sides among the four sets of opposite sides of the second bandpass filter (CFR), which are not in contact with the first bandpass filters (CFG), are in line contact with two sets of opposite sides among the four sets of opposite sides of the third bandpass filters (CFB), which are not in contact with the first bandpass filters (CFG), via the light absorption layers (BM).

In an example, the length of the two sets of opposite sides among the four sets of opposite sides of the second bandpass filter (CFR), which are not in contact with the first bandpass filters (CFG), is shorter than the length of the two sets of opposite sides among the four sets of opposite sides of the second bandpass filter (CFR), which are in line contact with the first bandpass filters (CFG). Also, the length of the two sets of opposite sides among the four sets of opposite sides of the third bandpass filter (CFB), which are not in contact with the first bandpass filters (CFG), is shorter than the length of the two sets of opposite sides among the four sets of opposite sides of the third bandpass filter (CFB), which are in line contact with the first bandpass filters (CFG).

As exemplified in Figs. 1A and 1C, in the first embodiment, a plurality of microlenses ML that form a microlens array MLA are provided. Note that ML is used as a symbol including both ML1 and ML2, and ML1 and ML2 are used to distinguish two types of microlenses ML from each other. The plurality of microlenses ML are arranged such that one microlens ML is assigned to each of the plurality of first bandpass filters, the plurality of second bandpass filters, and the plurality of third bandpass filters. Fig. 1C shows an example in which the light absorption layers BM are provided between the bandpass filters.

The plurality of color filters that form the color filter layer CFL can be classified into a first group formed by the plurality of first bandpass filters (CFG), a second group formed by the plurality of second bandpass filters (CFR), and a third group formed by the plurality of third bandpass filters (CFB). The plurality of microlenses ML can include a plurality of first microlenses ML1 and a plurality of second microlenses ML2. The first microlens ML1 is the microlens ML assigned to each of the bandpass filters (CFG here) of one group among the three groups. The second microlens ML2 is the microlens assigned to each of the bandpass filters (CFR and CFB here) of the remaining two groups among the three groups. The bottom surface size of the first microlens ML1 is smaller than the bottom surface size of the second microlens ML2. The bottom surface size is, for example, the diameter or the maximum width. In the example shown in Fig. 1B, letting D1 be the bottom surface size of the first microlens ML1, and D2 be the bottom surface size of the second microlens ML2, D1 : D2 = 1 : 1.4.

In an orthographic projection to the light-emitting element array LEDA or in a plan view, one first microlens ML1 can be arranged in contact with four second microlenses ML2 that are arranged not in contact with each other. The radius of curvature of the lens surface of the first microlens ML1 may be smaller than the radius of curvature of the lens surface of the second microlens ML2.

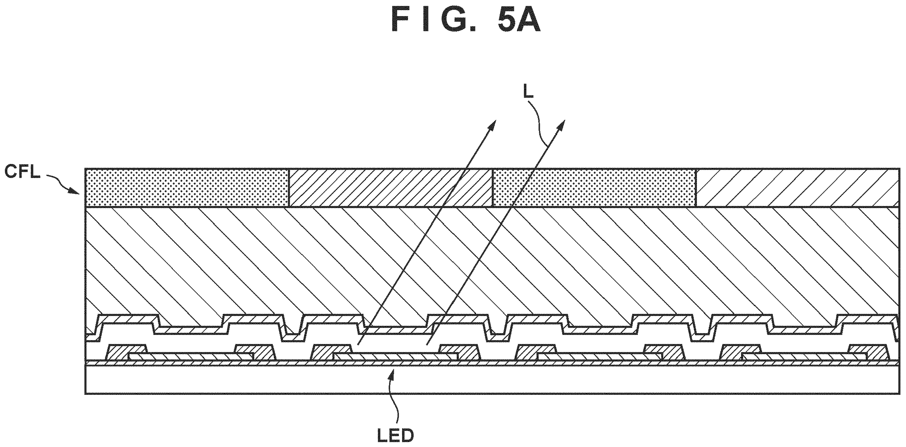

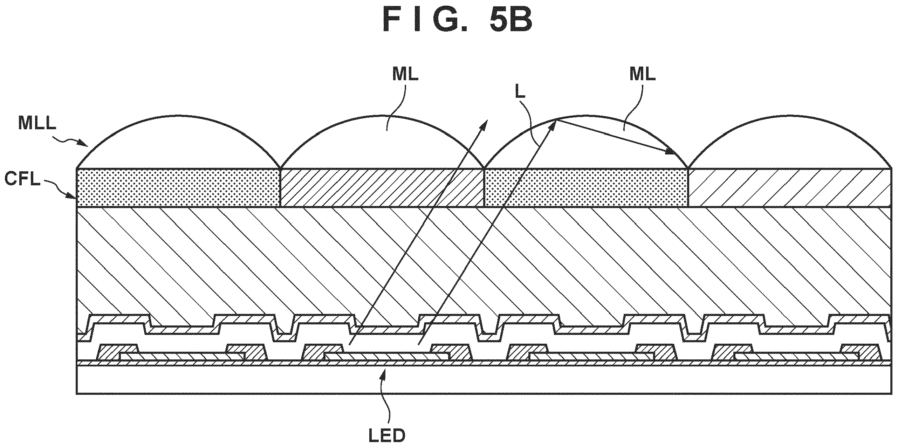

An effect obtained by arranging the microlenses ML or the microlens layer MLL on the color filter layer CFL will be described here with reference to Figs. 5A and 5B. From the light-emitting element LED, light L is radiated not only in the normal direction of the surface of the substrate but also in an oblique direction. If the microlenses ML do not exist, the light L obliquely radiated from the light-emitting element LED can pass through not a color filter assigned to the light-emitting element LED but a color filter assigned to an adjacent light-emitting element. This causes color mixing. On the other hand, if the microlenses ML exist, the light L obliquely radiated from the light-emitting element LED can pass through not a color filter assigned to the light-emitting element LED but a color filter assigned to an adjacent light-emitting element. However, most of the light L passed through the color filter assigned to the adjacent light-emitting element is then totally reflected by the microlens ML and does not pass through the microlens ML. This can prevent or reduce color mixing. In the present invention, the microlens or the microlens layer is not an indispensable component. However, the microlens or the microlens layer is advantageous in preventing or reducing color mixing, and is therefore a recommendable constituent element.

The light-emitting element array LEDA includes a plurality of light-emitting elements LED. Each light-emitting element LED can form one subpixel and include a subpixel electrode SPE. Here, a subpixel to which the color filter CFG that transmits green (G) light is assigned is a green (G) subpixel GSP. A subpixel to which the color filter CFR that transmits red (R) light is assigned is a red (R) subpixel GSR. A subpixel to which the color filter CFB that transmits blue (B) light is assigned is a blue (B) subpixel GSB. The periphery of each subpixel electrode SPE can be covered with the bank BNK including the opening OP. The opening OP can define the light-emitting region of each subpixel. The banks BNK that cover the plurality of subpixel electrodes SPE and their periphery can be covered with an organic film OF. A cathode electrode CE can be arranged on the organic film OF. The cathode electrode CE can be provided common to the plurality of subpixel electrodes SPE or the plurality of subpixels. The cathode electrode CE may be understood as an upper electrode or a common electrode. A sealing film (protection film) SF can be arranged on the cathode electrode CE, and the color filter layer CFL can be arranged on the sealing film SF. The microlens layer MLL can arbitrarily be arranged on the color filter layer CFL. Note that in the following embodiments, the cathode electrode CE is provided, but this can be omitted.

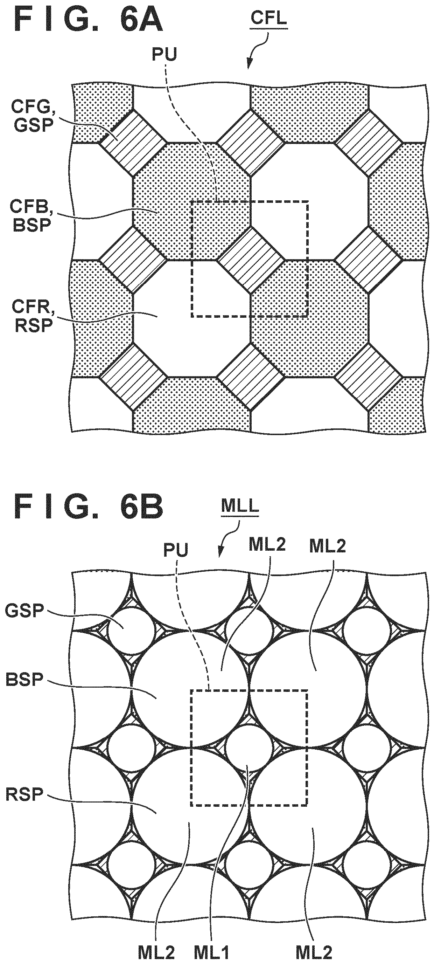

Fig. 6A is a plan view of a color filter layer CFL of a display device according to the second embodiment, and Fig. 6B is a plan view of a microlens layer MLL of the display device according to the second embodiment. Matters that are not mentioned as the second embodiment can comply with the first embodiment. The display device according to the second embodiment can have, for example, a sectional structure schematically shown in Fig. 3.

In the second embodiment as well, it is preferable that A/B < 2·C/B is satisfied, it is more preferable that A/B < 1.5·C/B is satisfied, and it is most preferable that A/B < 1.2·C/B is satisfied. Alternatively, B and C may have a value less than ±5% of A. Also, it is preferable that TA/TB ≦ 2·TC/TB is satisfied, it is more preferable that TA/TB < 1.5·TC/TB is satisfied, and it is most preferable that TA/TB < 1.2·TC/TB is satisfied. TB and TC may have a value less than ±5% of TA.

In the example shown in Figs. 6A and 6B, the areas A : B : C occupied by first bandpass filters (CFG), second bandpass filters (CFR), and third bandpass filters (CFB) in a unit pixel region PU satisfy 0.44 : 1.28 : 1.28. Hence, A/B = 0.34, and CB = 1. Also, in the example shown in Fig. 6, the total areas TA : TB : TC occupied by the first bandpass filters (CFG), the second bandpass filters (CFR), and the third bandpass filters (CFB) in a light-emitting element array LEDA satisfy 0.44 : 1.28 : 1.28. Hence, TA/TB = 0.34, and TC/TB = 1.

In the example shown in Figs. 6A and 6B, the area of a blue (B) subpixel BSP can be made larger than in the example shown in Figs. 1A to 1C. This is advantageous in reducing the current density of the blue (B) subpixel BSP and can function to increase the life of the blue subpixel BSP that generally has a short life.

As exemplified in Figs. 6A and 6B, in the second embodiment, a plurality of microlenses ML that form a microlens array MLA are provided. The plurality of microlenses ML are arranged such that one microlens ML is assigned to each of the plurality of first bandpass filters, the plurality of second bandpass filters, and the plurality of third bandpass filters.

The plurality of color filters that form the color filter layer CFL can be classified into a first group formed by the plurality of first bandpass filters (CFG), a second group formed by the plurality of second bandpass filters (CFR), and a third group formed by the plurality of third bandpass filters (CFB). The plurality of microlenses ML can include a plurality of first microlenses ML1 and a plurality of second microlenses ML2. The first microlens ML1 is the microlens ML assigned to each of the bandpass filters (CFG here) of one group among the first, second, and third groups. The second microlens ML2 is the microlens assigned to each of the bandpass filters (CFR and CFB here) of the remaining two groups among the first, second, and third loops. The bottom surface size of the first microlens ML1 is smaller than the bottom surface size of the second microlens ML2. The bottom surface size is, for example, the diameter or the maximum width. In the example shown in Fig. 6(b), letting D1 be the bottom surface size of the first microlens ML1, and D2 be the bottom surface size of the second microlens ML2, D1 : D2 = 1 : 2.41.

The plurality of first bandpass filters (CFG in the second embodiment) each have a square shape and are arranged apart from each other in a square grating pattern. The plurality of second bandpass filters (CFR in the second embodiment) and the plurality of third bandpass filters (CFB in the second embodiment) each have an octagonal shape formed by four sets of parallel opposite sides. Two second bandpass filters (CFR) are in line contact with one set of opposite sides of the square of the first bandpass filter (CFG), and two third bandpass filters (CFB) are in line contact with the other set of opposite sides of the square of the first bandpass filter (CFG). Two sets of opposite sides among the four sets of opposite sides of the second bandpass filter (CFR), which are not in contact with the first bandpass filters (CFG), are in line contact with two sets of opposite sides among the four sets of opposite sides of the third bandpass filters (CFB), which are not in contact with the first bandpass filters (CFG).

In this embodiment as well, for the purpose of reducing color mixing, light absorption layers may be provided between the bandpass filters, and the bandpass filters may be in line contact via the light absorption layers.

The length of the two sets of opposite sides among the four sets of opposite sides of the second bandpass filter (CFR), which are not in contact with the first bandpass filters (CFG), can be equal to or longer than the length of the two sets of opposite sides among the four sets of opposite sides of the second bandpass filter (CFR), which are in line contact with the first bandpass filters (CFG). The length of the two sets of opposite sides among the four sets of opposite sides of the third bandpass filter (CFB), which are not in contact with the first bandpass filters (CFG), can be equal to or longer than the length of the two sets of opposite sides among the four sets of opposite sides of the third bandpass filter (CFB), which are in line contact with the first bandpass filters (CFG).

In the second embodiment, in an orthographic projection to the light-emitting element array LEDA or in a plan view, one first microlens ML1 is arranged in contact with four second microlenses ML2 that are arranged in contact with each other. The radius of curvature of the lens surface of the first microlens ML1 is smaller than the radius of curvature of the lens surface of the second microlens ML2.

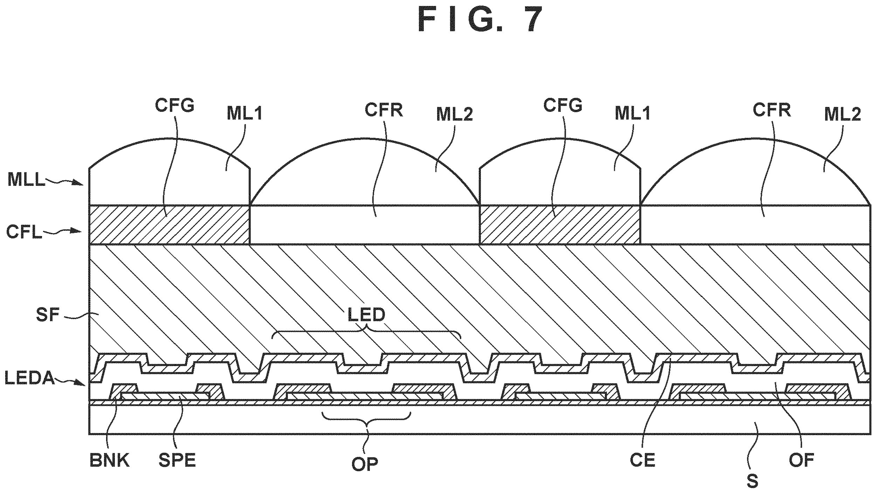

Fig. 7 shows the sectional structure of a display device according to the third embodiment. The third embodiment is a modification of the first or second embodiment, and the configuration of a microlens layer MLL is different from that in the display devices according to the first and second embodiments, but the rest of the configuration can comply with the configuration of the display device according to the first or second embodiment.

The radius of curvature of the lens surface of a first microlens ML1 can be less than $\pm20\%$, less than $\pm10\%$, or less than $\pm5\%$ of the radius of curvature of the lens surface of a second microlens ML2. Alternatively, the radius of curvature of the lens surface of the first microlens ML1 equals the radius of curvature of the lens surface of the second microlens ML2.

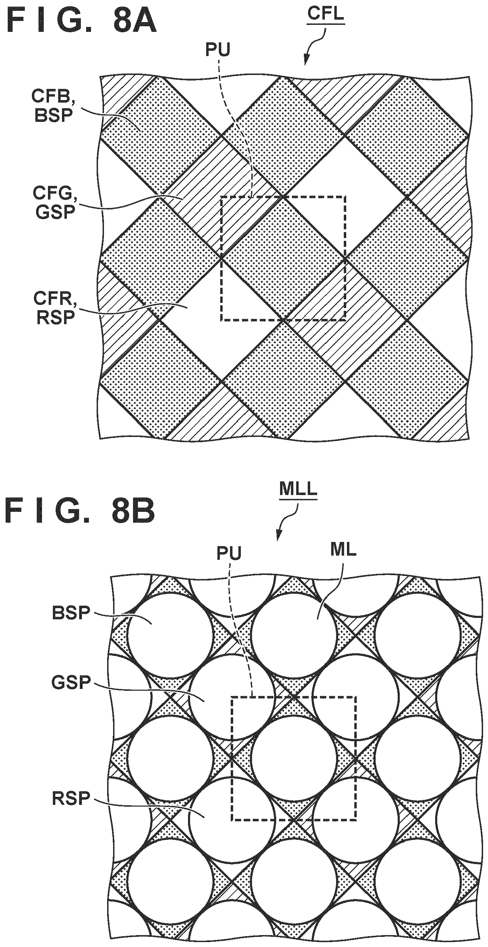

Fig. 8A is a plan view of a color filter layer CFL of a display device according to the fourth embodiment, and Fig. 8B is a plan view of a microlens layer MLL of the display device according to the fourth embodiment. Matters that are not mentioned as the fourth embodiment can comply with one of the first to third embodiments.

A plurality of color filters that form the color filter layer CFL according to the fourth embodiment can have the same shape (and the same size). In other words, first bandpass filters, second bandpass filters, and third bandpass filters can have the same shape (and the same size). However, color filters in contact with the boundary of the light-emitting element array can have sizes and shapes different from those of the remaining color filters. The first bandpass filters, the second bandpass filters, and the third bandpass filters can have a square shape. In another viewpoint, the first bandpass filters, the second bandpass filters, and the third bandpass filters can have a rectangular shape or a rhombic shape.

In the fourth embodiment, the first bandpass filter is a bandpass filter CFB that transmits blue (B) light, the second bandpass filter is a bandpass filter CFG that transmits green (G) light, and the third bandpass filter is a bandpass filter CFR that transmits red (R) light. However, these may be replaced with each other.

In the example shown in Figs. 8A and 8B, areas A : B : C occupied by the first bandpass filters (CFB), the second bandpass filters (CFG), and the third bandpass filters (CFR) in a unit pixel region PU satisfy 1.5 : 0.75 : 0.75. Hence, A/B = 2, and C/B = 1. Also, in the example shown in Figs. 8A and 8B, total areas TA : TB : TC occupied by the first bandpass filters (CFB), the second bandpass filters (CFG), and the third bandpass filters (CFR) in a light-emitting element array LEDA satisfy 1.5 : 0.75 : 0.75. Hence, TA/TB = 2, and TC/TB = 1.

In the example shown in Figs. 8A and 8B, an area occupied by the first bandpass filters, that is, the blue bandpass filters CFB in a unit pixel region PU is larger than an area occupied by the second filters, that is, the bandpass filters CFG that transmit green light in the unit pixel region PU. In the example shown in Fig. 8, the area occupied by the first bandpass filters, that is, the blue bandpass filters CFB in the unit pixel region PU is larger than an area occupied by the third bandpass filters, that is, the bandpass filters CFR that transmit red light in the unit pixel region PU. This is advantageous in reducing the current density of a blue (B) subpixel BSP and can function to increase the life of the blue subpixel BSP that generally has a short life.

In an orthographic projection to the light-emitting element array LEDA or in a plan view, the maximum value of the bottom surface size of a plurality of microlenses ML is less than 1.2 times, 1.1 times, or 1.05 times the minimum value. Alternatively, in an orthographic projection to the light-emitting element array LEDA or in a plan view, the maximum value of the height of the plurality of microlenses ML is less than 1.2 times, 1.1 times, or 1.05 times the minimum value.

Alternatively, in an orthographic projection to the light-emitting element array LEDA or in a plan view, the maximum value of the radius of curvature of the plurality of microlenses ML is less than 1.2 times, 1.1 times, or 1.05 times the minimum value. Alternatively, in an orthographic projection to the light-emitting element array LEDA or in a plan view, the plurality of microlenses ML can have the same shape and the same size. Here, "same shape and same size" is used in a sense of allowing a manufacturing error.

The microlens layer MLL formed by the plurality of microlenses ML as described above can easily be manufactured and is advantageous in making view angle characteristic uniform.

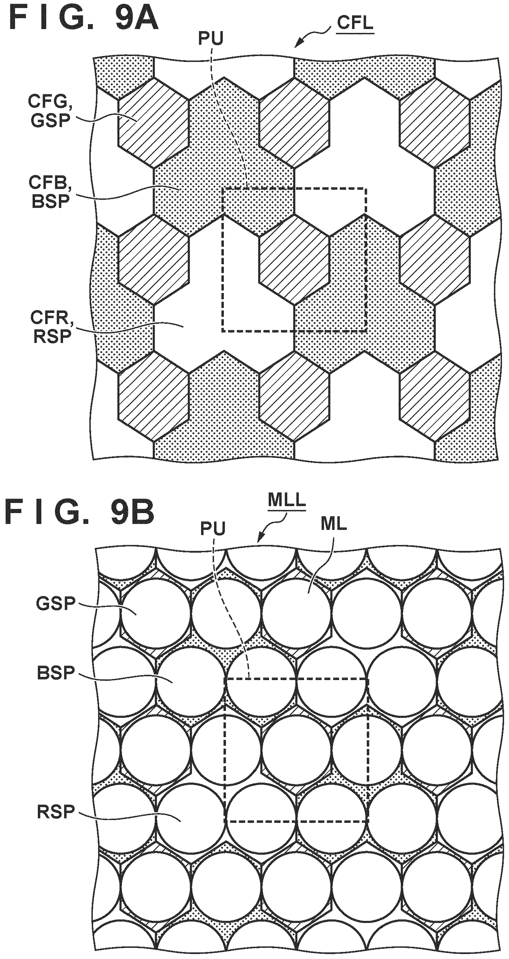

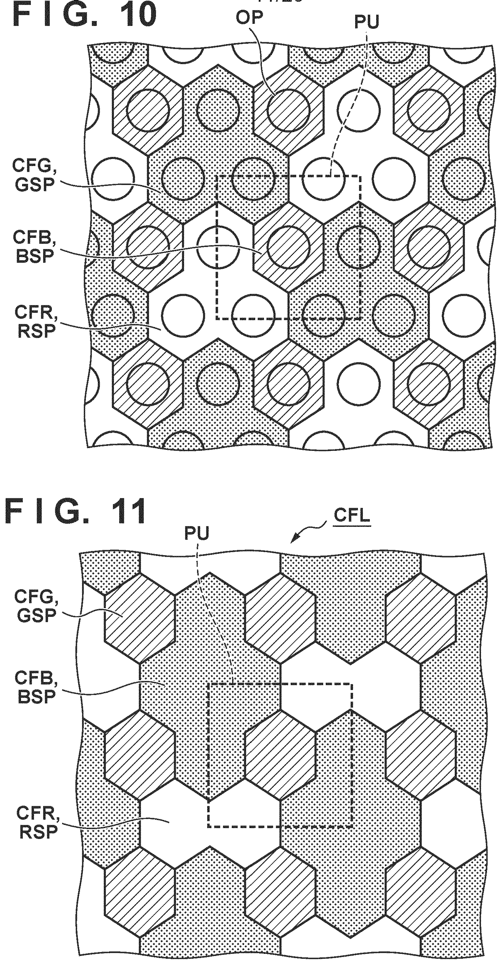

Fig. 9A is a plan view of a color filter layer CFL of a display device according to the fifth embodiment, and Fig. 9B is a plan view of a microlens layer MLL of the display device according to the fifth embodiment. Matters that are not mentioned as the fifth embodiment can comply with one of the first to fourth embodiments. Fig. 10 shows an opening OP provided in a bank BNK of the display device according to the fifth embodiment.

In the fifth embodiment, a first bandpass filter is a bandpass filter CFG that transmits green (G) light, a second bandpass filter is a bandpass filter CFR that transmits red (R) light, and a third bandpass filter is a bandpass filter CFB that transmits blue (B) light. However, these may be replaced with each other.

The first bandpass filter (CFG) has a hexagonal shape formed by three sets of parallel opposite sides. The second bandpass filter (CFR) has a shape obtained by connecting three hexagons each formed by three sets of parallel opposite sides such that these share two sides adjacent to each other. The third bandpass filter (CFB) has a shape obtained by connecting three hexagons each formed by three sets of parallel opposite sides such that these share two sides adjacent to each other. These hexagons may or may not be regular hexagons.

In the example shown in Figs. 9A and 9B, areas A : B : C occupied by the first bandpass filters (CFG), the second bandpass filters (CFR), and the third bandpass filters (CFB) in a unit pixel region PU satisfy 1.2 : 0.8 : 1.2. Hence, A/B = 2/3, and CB = 1. Also, in the example shown in Figs. 9A and 9B, total areas TA : TB : TC occupied by the first bandpass filters (CFG), the second bandpass filters (CFR), and the third bandpass filters (CFB) in a light-emitting element array LEDA satisfy 1.2 : 0.8 : 1.2. Hence, TA/TB = 2/3, and TC/TB = 1.

In the example shown in Figs. 9A and 9B, the area of a blue (B) subpixel BSP can be made largest. Alternatively, in the example shown in Figs. 9A and 9B, the area of the blue (B) subpixel BSP can be made larger than that of a green (G) subpixel GSP. This is advantageous in reducing the current density of the blue (B) subpixel BSP and can function to increase the life of the blue subpixel BSP that generally has a short life.

A plurality of light-emitting elements LED can be arranged such that one light-emitting element LED corresponds to one color filter. The microlens array MLL including a plurality of microlenses ML arranged on the color filter layer CFL can be arranged. The plurality of microlenses ML can be arranged such that one microlens ML is assigned to one hexagon. Each of the plurality of light-emitting elements LED can be provided with openings as many as the microlenses ML assigned to a corresponding bandpass filter. More specifically, the light-emitting element LED of the green (G) subpixel GSP can be provided with one light-emitting element LED, one opening O, and one microlens ML. The light-emitting element LED of a red (R) subpixel GSR can be provided with one light-emitting element LED, three openings OP, and three microlenses. The light-emitting element LED of the blue (B) subpixel GSB can be provided with one light-emitting element LED, three openings OP, and three microlenses.

The plurality of color filters that form the color filter layer CFL can be classified into a first group formed by the plurality of first bandpass filters (CFG), a second group formed by the plurality of second bandpass filters (CFR), and a third group formed by the plurality of third bandpass filters (CFB). In one viewpoint, at least two microlenses are assigned to each of the bandpass filters (CFR and CFR) of two groups, more specifically, the second group and the third group among the first, second, and third groups. In another viewpoint, at least three microlenses are assigned to each of the bandpass filters (CFR and CFR) of two groups, more specifically, the second group and the third group among the first, second, and third groups.

Fig. 11 is a plan view of a color filter layer CFL of a display device according to the sixth embodiment. In the sixth embodiment, a first bandpass filter is a bandpass filter CFG that transmits green (G) light, a second bandpass filter is a bandpass filter CFR that transmits red (R) light, and a third bandpass filter is a bandpass filter CFB that transmits blue (B) light. However, these may be replaced with each other.

The first bandpass filter (CFG) has a hexagonal shape formed by three sets of parallel opposite sides. The second bandpass filter (CFR) has a shape obtained by connecting two hexagons each formed by three sets of parallel opposite sides. The third bandpass filter (CFB) has a shape obtained by connecting four hexagons each formed by three sets of parallel opposite sides such that a cross shape is formed. In other words, the center of gravity of each of the four hexagons can be arranged on a vertex of a virtual rhombus.

In the example shown in Fig. 11, areas A : B : C occupied by the first bandpass filters (CFG), the second bandpass filters (CFR), and the third bandpass filters (CFB) in a unit pixel region PU satisfy 0.75 : 0.75 : 1.5. Hence, A/B = 1, and C/B = 2. Also, in the example shown in Fig. 11, total areas TA : TB : TC occupied by the first bandpass filters (CFG), the second bandpass filters (CFR), and the third bandpass filters (CFB) in a light-emitting element array LEDA satisfy 0.75 : 0.75 : 1.5. Hence, TA/TB = 1, and TC/TB = 2.

In the example shown in Fig. 11, the area of a blue (B) subpixel BSP can be made largest. Alternatively, in the example shown in Fig. 11, the area of the blue (B) subpixel BSP can be made larger than that of a green (G) subpixel GSP. This is advantageous in reducing the current density of the blue (B) subpixel BSP and can function to increase the life of the blue subpixel BSP that generally has a short life.

A plurality of light-emitting elements LED can be arranged such that one light-emitting element LED corresponds to one color filter. A microlens array MLL including a plurality of microlenses ML arranged on the color filter layer CFL can be arranged. The plurality of microlenses ML can be arranged such that one microlens ML is assigned to one hexagon. Each of the plurality of light-emitting elements LED can be provided with openings as many as the microlenses ML assigned to a corresponding bandpass filter. More specifically, the light-emitting element LED of the green (G) subpixel GSP can be provided with one light-emitting element LED, one opening OP, and one microlens ML. The light-emitting element LED of a red (R) subpixel GSR can be provided with one light-emitting element LED, two openings OP, and two microlenses. The light-emitting element LED of the blue (B) subpixel GSB can be provided with one light-emitting element LED, four openings OP, and four microlenses.

The plurality of color filters that form the color filter layer CFL can be classified into a first group formed by the plurality of first bandpass filters (CFG), a second group formed by the plurality of second bandpass filters (CFR), and a third group formed by the plurality of third bandpass filters (CFB). In one viewpoint, one microlens ML is assigned to each of the bandpass filters (CFG) of one group, more specifically, the first group among the first, second, and third groups. Also, two microlenses ML are assigned to each of the bandpass filters (CFR) of another group, more specifically, the second group among the first, second, and third groups. Also, four microlenses ML are assigned to each of the bandpass filters (CFB) of still another group, more specifically, the third group among the first, second, and third groups.

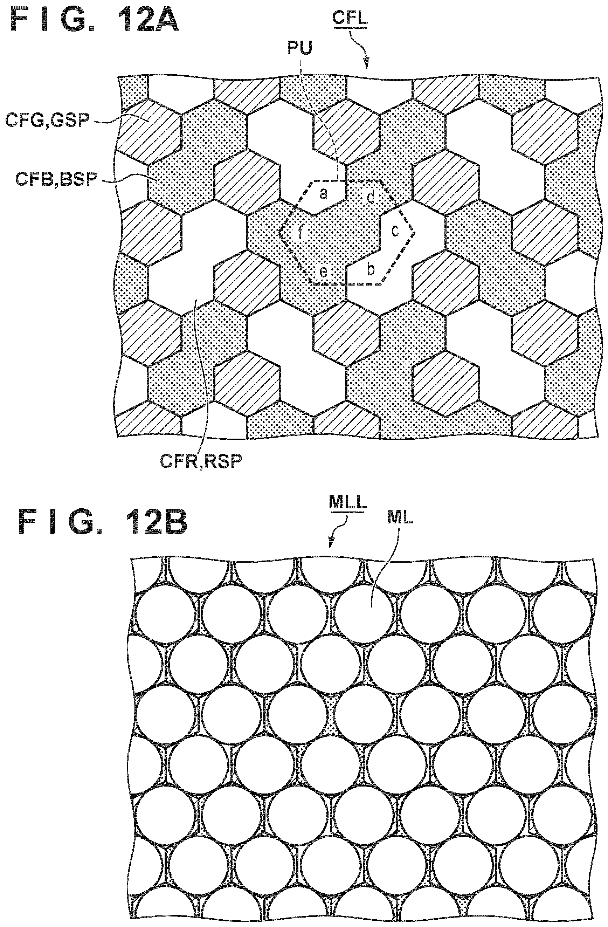

Figs. 12A and 12B are plan views of a color filter layer CFL of a display device according to the seventh embodiment. In the seventh embodiment, a first bandpass filter is a bandpass filter CFG that transmits green (G) light, a second bandpass filter is a bandpass filter CFR that transmits red (R) light, and a third bandpass filter is a bandpass filter CFB that transmits blue (B) light. However, these may be replaced with each other.

The first bandpass filter (CFG) has a hexagonal shape formed by three sets of parallel opposite sides. The second bandpass filter (CFR) has a shape obtained by connecting two hexagons each formed by three sets of parallel opposite sides. The third bandpass filter (CFB) has a shape obtained by connecting two hexagons each formed by three sets of parallel opposite sides.

The first bandpass filter (CFG) includes a first side a, a second side b parallel to the first side a, a third side c connected to the second side b, a fourth side d that connects the third side c and the first side a, a fifth side e parallel to the fourth side d, and a sixth side f that connects the fifth side e and the first side a. The first side a is in line contact with one side of one second bandpass filter (CFR). The second side b and the third side c are in line contact with two sides of another second bandpass filter (CFR), respectively. The fourth side d is in line contact with one side of one third bandpass filter (CFB). The fifth side and the sixth side are in line contact with two sides of another third bandpass filter (CFB).

In this embodiment as well, for the purpose of reducing color mixing, light absorption layers may be provided between the bandpass filters, and the bandpass filters may be in line contact via the light absorption layers.

In the example shown in Figs. 12A and 12B, areas A : B : C occupied by the first bandpass filters (CFG), the second bandpass filters (CFR), and the third bandpass filters (CFB) in a unit pixel region PU satisfy 1 : 1 : 1. Hence, A/B = CB = 1. Also, in the example shown in Figs. 12A and 12B, total areas TA : TB : TC occupied by the first bandpass filters (CFG), the second bandpass filters (CFR), and the third bandpass filters (CFB) in a light-emitting element array LEDA satisfy 1 : 1 : 1. Hence, TA/TB = TC/TB = 1.

A plurality of light-emitting elements LED can be arranged such that one light-emitting element LED corresponds to one color filter. A microlens array MLL including a plurality of microlenses ML arranged on the color filter layer CFL can be arranged. The plurality of microlenses ML can be arranged such that one microlens ML is assigned to one hexagon. Each of the plurality of light-emitting elements LED can be provided with openings as many as the microlenses ML assigned to a corresponding bandpass filter. More specifically, the light-emitting element LED of a green (G) subpixel GSP can be provided with one light-emitting element LED, one opening OP, and one microlens ML. The light-emitting element LED of a red (R) subpixel GSR can be provided with one light-emitting element LED, two openings OP, and two microlenses. The light-emitting element LED of a blue (B) subpixel GSB can be provided with one light-emitting element LED, two openings OP, and two microlenses.

The plurality of color filters that form the color filter layer CFL can be classified into a first group formed by the plurality of first bandpass filters (CFG), a second group formed by the plurality of second bandpass filters (CFR), and a third group formed by the plurality of third bandpass filters (CFB). In one viewpoint, one microlens ML is assigned to each of the bandpass filters (CFG) of one group, more specifically, the first group among the first, second, and third groups. Also, two microlenses ML are assigned to each of the bandpass filters of the remaining two groups, more specifically, each of the bandpass filters (CFR) of the second group and the bandpass filters (CFR) of the third group among the first, second, and third groups.

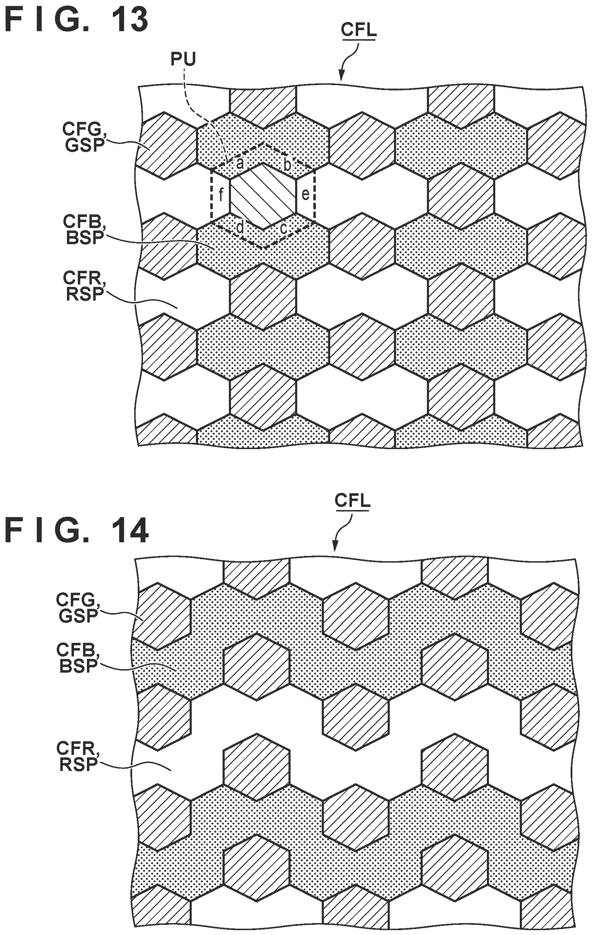

Fig. 13 is a plan view of a color filter layer CFL of a display device according to the eighth embodiment. In the eighth embodiment, a first bandpass filter is a bandpass filter CFG that transmits green (G) light, a second bandpass filter is a bandpass filter CFR that transmits red (R) light, and a third bandpass filter is a bandpass filter CFB that transmits blue (B) light. However, these may be replaced with each other.

The first bandpass filter (CFG) has a hexagonal shape formed by three sets of parallel opposite sides. The second bandpass filter (CFR) has a shape obtained by connecting two hexagons each formed by three sets of parallel opposite sides. The third bandpass filter (CFB) has a shape obtained by connecting two hexagons each formed by three sets of parallel opposite sides.

The first bandpass filter (CFG) includes a first side a, a second side b connected to the first side a, a third side c parallel to the first side a, a fourth side d parallel to the second side b, a fifth side e that connects the second side b and the third side c, and a sixth side f that connects the first side a and the fourth side d. The fifth side e and the sixth side f are each in line contact with one side of a corresponding one of second bandpass filters (CFR) different from each other. The first side a and the second side b are in line contact with two sides of one third bandpass filter (CFB), respectively. The third side c and the fourth side d are in line contact with two sides of another third bandpass filter (CFB).

In this embodiment as well, light absorption layers may be provided between the bandpass filters, and the bandpass filters may be in line contact via the light absorption layers.

In the example shown in Fig. 13, areas A : B : C occupied by the first bandpass filters (CFG), the second bandpass filters (CFR), and the third bandpass filters (CFB) in a unit pixel region PU satisfy 1 : 1 : 1. Hence, A/B = CB = 1. Also, in the example shown in Fig. 13, total areas TA : TB : TC occupied by the first bandpass filters (CFG), the second bandpass filters (CFR), and the third bandpass filters (CFB) in a light-emitting element array LEDA satisfy 1 : 1 : 1. Hence, TA/TB = TC/TB = 1.

A plurality of light-emitting elements LED can be arranged such that one light-emitting element LED corresponds to one color filter. A microlens array MLL including a plurality of microlenses ML arranged on the color filter layer CFL can be arranged. The plurality of microlenses ML can be arranged such that one microlens ML is assigned to one hexagon. Each of the plurality of light-emitting elements LED can be provided with openings as many as the microlenses ML assigned to a corresponding bandpass filter. More specifically, the light-emitting element LED of a green (G) subpixel GSP can be provided with one light-emitting element LED, one opening OP, and one microlens ML. The light-emitting element LED of a red (R) subpixel GSR can be provided with one light-emitting element LED, two openings OP, and two microlenses. The light-emitting element LED of a blue (B) subpixel GSB can be provided with one light-emitting element LED, two openings OP, and two microlenses.

The plurality of color filters that form the color filter layer CFL can be classified into a first group formed by the plurality of first bandpass filters (CFG), a second group formed by the plurality of second bandpass filters (CFR), and a third group formed by the plurality of third bandpass filters (CFB). In one viewpoint, one microlens ML is assigned to each of the bandpass filters (CFG) of one group, more specifically, the first group among the first, second, and third groups. Also, two microlenses ML are assigned to each of the bandpass filters of the remaining two groups, more specifically, each of the bandpass filters (CFR) of the second group and the bandpass filters (CFR) of the third group among the first, second, and third groups.

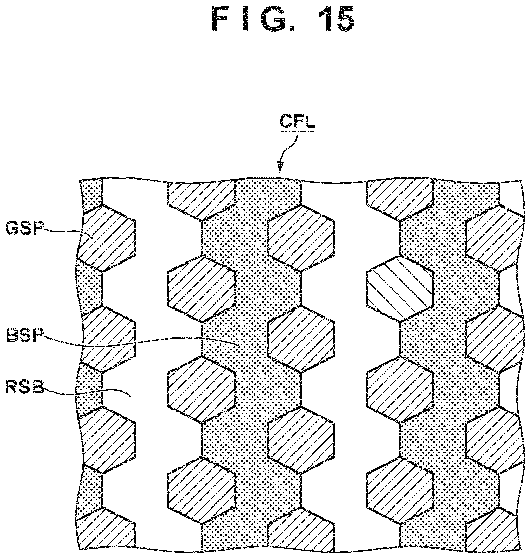

Fig. 14 is a plan view of a color filter layer CFL of a display device according to the ninth embodiment. Fig. 15 is a plan view of a color filter layer CFL of a display device according to the 10th embodiment. Hereinafter, the ninth and 10th embodiments will be described together. In the ninth and 10th embodiments, a first bandpass filter is a bandpass filter CFG that transmits green (G) light, a second bandpass filter is a bandpass filter CFR that transmits red (R) light, and a third bandpass filter is a bandpass filter CFB that transmits blue (B) light. However, these may be replaced with each other.

The first bandpass filter (CFG) has a hexagonal shape formed by three sets of parallel opposite sides. The second bandpass filter (CFR) has a shape obtained by connecting a plurality of hexagons each formed by three sets of parallel opposite sides such that two opposite sides of a light-emitting element array LEDA are connected. The third bandpass filter (CFB) has a shape obtained by connecting a plurality of hexagons each formed by three sets of parallel opposite sides such that the two opposite sides of the light-emitting element array LEDA are connected.

In the examples shown in Figs. 14 and 15, areas A : B : C occupied by the first bandpass filters (CFG), the second bandpass filters (CFR), and the third bandpass filters (CFB) in a unit pixel region PU satisfy 1 : 1 : 1. Hence, A/B = CB = 1. Also, in the examples shown in Figs. 14 and 15, total areas TA : TB : TC occupied by the first bandpass filters (CFG), the second bandpass filters (CFR), and the third bandpass filters (CFB) in a light-emitting element array LEDA satisfy 1 : 1 : 1. Hence, TA/TB = TC/TB = 1.

A plurality of light-emitting elements LED can be arranged such that one light-emitting element LED corresponds to one color filter. A microlens array MLL including a plurality of microlenses ML arranged on the color filter layer CFL can be arranged. The plurality of microlenses ML can be arranged such that one microlens ML is assigned to one hexagon. Each of the plurality of light-emitting elements LED can be provided with openings as many as the microlenses ML assigned to a corresponding bandpass filter.

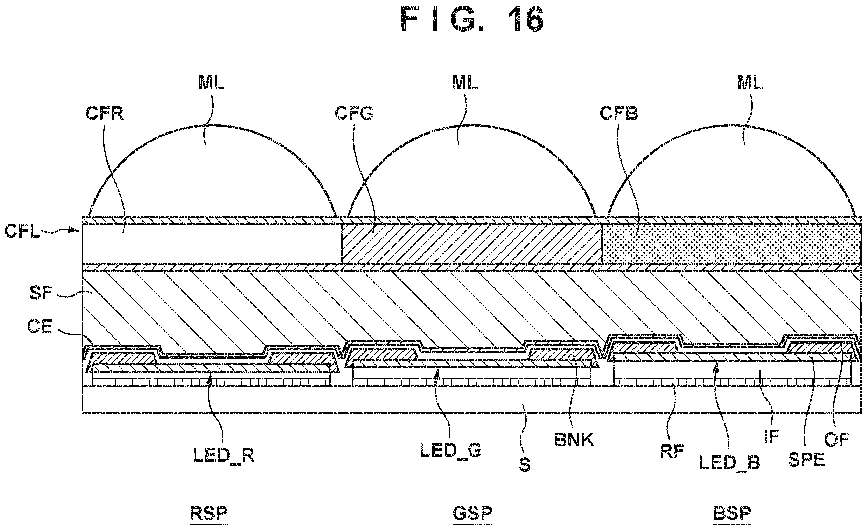

Additional techniques applicable to the above-described first to 10th embodiments will be described below. Fig. 16 schematically shows the sectional structures of the subpixels GSP, RS, and BSP including the green (G) color filter CFG, the red (R) color filter CFR, and the blue (B) color filter CFB, respectively.

The subpixel electrodes SPE of the subpixels GSP, RS, and BSP can be arranged on reflection films RF with insulating films IF interposed therebetween. The reflection film RF can have a thickness according to the color assigned to each of the subpixels GSP, RS, and BSP in which it is provided. Thus, wavelengths according to the colors assigned to the subpixels GSP, RS, and BSP or light in which the bands of the colors assigned to the subpixels GSP, RS, and BSP are enhanced can be radiated to the color filter layer CFF. Here, the reflection film RF, the insulating film IF, the subpixel electrode SPE, and the bank BNK can be formed by lithography advantageous in forming a fine structure. The color filter layer CFL and the microlens layer MLL can also be formed by lithography.

The thicknesses of the insulating films IF in the subpixels GSP, RS, and BSP for optimizing the distance (optical distance) between the reflection film RF and the light-emitting layer of the organic film OF for the bands transmitted by the color filters CFG, CFR, and CFB will be described. Letting $Lr$ be the optical path length from the upper surface of the reflection film RF to the light-emitting layer of the organic film OF, and $\Phi r$ be the phase shift in the reflection film RF, equation (1) holds.

$$Lr = \{2m - (\Phi r/\pi)\} \times (\lambda/4) \qquad \qquad ...(1)$$

where m is an integer (nonnegative integer) of 0 or more. The thickness of the insulating film IF in each of the subpixels GSP, RS, and BSP can be decided such that equation (1) is substantially satisfied.

Letting $\Phi s$ be the phase shift when light having the wavelength $\lambda$ is reflected by the lower surface of the cathode electrode CE, an optical distance $Ls$ from the light-emitting layer of the organic film OF to the lower surface of the cathode electrode CE substantially satisfies equation (2). In this configuration, m' = 0.

$$Ls = \{2m' - (\Phi s/\pi)\} \times (\lambda/4) = -(\Phi s/\pi) \times (\lambda/4) \qquad \qquad ...(2)$$

Hence, a total layer interference L substantially satisfies equation (3).

$$L = Lr + L = (2m - \Phi/\pi) \times (\lambda/4) \qquad \qquad ...(3)$$

where $\Phi$ is the sum $(\Phi r + \Phi s)$ of the phase shifts when the light having the wavelength $\lambda$ is reflected by the reflection film RF and the cathode electrode CE.

The subpixel electrode SPE may be formed by a transparent conductive film that transmits visible light, can be made of, for example, ITO, IZO, aluminum zinc oxide (AZO), or indium gallium zinc oxide (IGZO). The bank BNK may be provided to cover the outer peripheral portion of the subpixel electrode SPE. The bank BNK can be made of, for example, an inorganic insulating material such as SiN, SiON, or SiO or an organic insulating material such as an acrylic resin or a polyimide resin.

The organic film OF can be arranged to cover the subpixel electrode SPE. The organic film OF can be formed by, for example, a known technique such as vapor deposition or spin coating. The organic film OF can be formed by a plurality of layers including a light-emitting layer. Examples of the plurality of layers are a hole injection layer, a hole transport layer, an electron block layer, a light-emitting layer, a hole block layer, an electron transport layer, and an electron injection layer. The organic film OF radiates light when holes injected from an anode (subpixel electrode SPE) and electrons injected from a cathode (cathode electrode CE) are recombined in the light-emitting layer. As for the structure, the light-emitting layer may be formed by a single layer or a plurality of layers. The light-emitting layer can contain a red light-emitting material, a green light-emitting material, and a red light-emitting material, and white light can be obtained by mixing the light emission colors. The light-emitting layer may contain light-emitting materials with a complementary color relationship such as a blue light-emitting material and a yellow light-emitting material.

The cathode electrode CE is arranged on the organic film OF and has light transmissivity. The cathode electrode CE may be made of a semitransparent material having such a characteristic (that is, semi-transmissive reflectivity) that transmits some components of light that has reached its lower surface and reflects the remaining components. The cathode electrode CE can be made of, for example, a transparent material such as a transparent conductive oxide. The cathode electrode CE may be made of a single metal such as Al, Ag, or Au, or an alkali metal such as lithium (Li) or cesium (Cs). The cathode electrode CE may be made of an alkali earth metal such as magnesium (Mg), calcium (Ca), or barium (Ba). The cathode electrode CE may be made of a semitransparent material such as an alloy material containing these metal materials. The cathode electrode CE may have a stacked structure of the above-described materials.

The sealing film SF can be formed to cover the organic film OF including the light-emitting layer. The sealing film OF may contain an inorganic material that has light transmissivity and low permeability to oxygen or water from the outside. The sealing film SF can be made of, for example, an inorganic material such as SiN, SiON, SiO, aluminum oxide ($Al_2O_3$), or titanium oxide ($TiO_2$). The sealing film SF can be formed by, for example, CVD, atomic layer deposition (ALD), or sputtering. The sealing film SF may have a single layer structure if sufficient water block performance is ensured, may have a stacked structure formed by combining the above-described materials or forming methods.

A planarization film may be arranged on the sealing film SF. The planarization film can be made of a material having light transmissivity. The planarization film may be made of an inorganic material or an organic material. The color filter layer CFL can be arranged on the sealing film SF or the planarization layer.

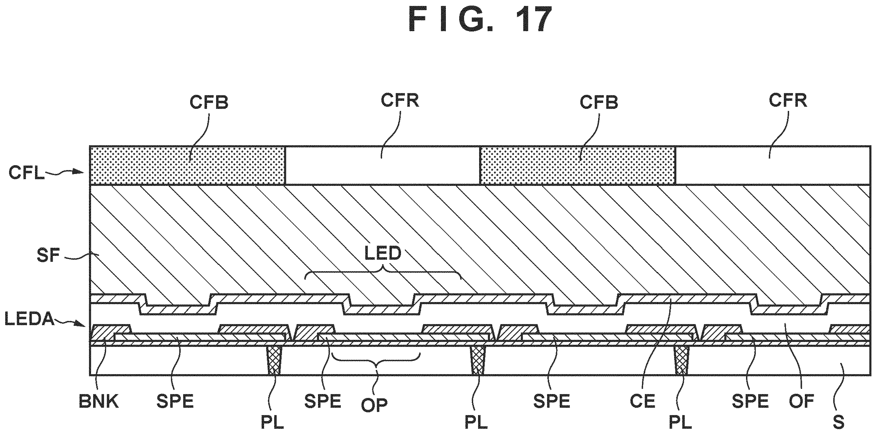

Fig. 17 exemplarily shows a plug PL. The plug PL can be provided to maintain the cathode electrode CE at a fixed potential. The plug PL can be arranged to, for example, connect the cathode electrode CE to a ground line. For example, in an orthographic projection to the light-emitting element array LEDA or in a plan view, the plug PL can be arranged between the microlens ML and the microlens ML.

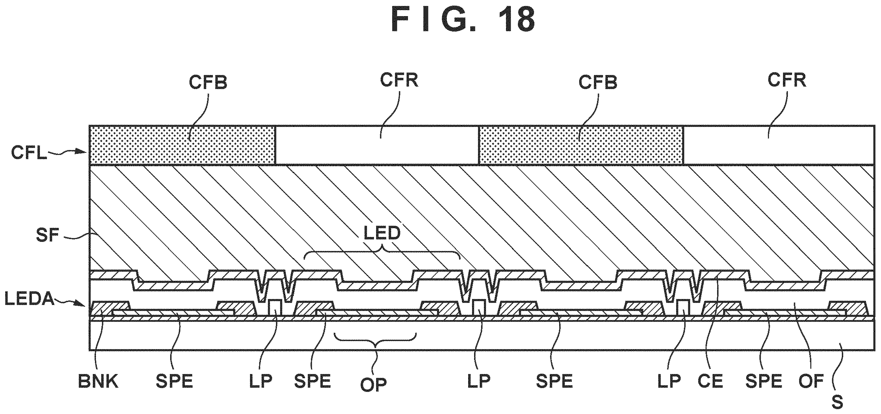

Fig. 18 exemplarily shows a leakage reduction structure LP. The leakage reduction structure LP can be arranged to reduce a leakage current between subpixels. The leakage reduction portion LP can be arranged to, for example, make the organic film OF between subpixels thinner than the organic film OF in a subpixel. The leakage reduction portion LP can include, for example, a convex portion or a concave portion. For example, in an orthographic projection to the light-emitting element array LEDA or in a plan view, the leakage reduction structure LP can be arranged between the microlens ML and the microlens ML.

Application examples of the above-described display device will exemplarily be described below.

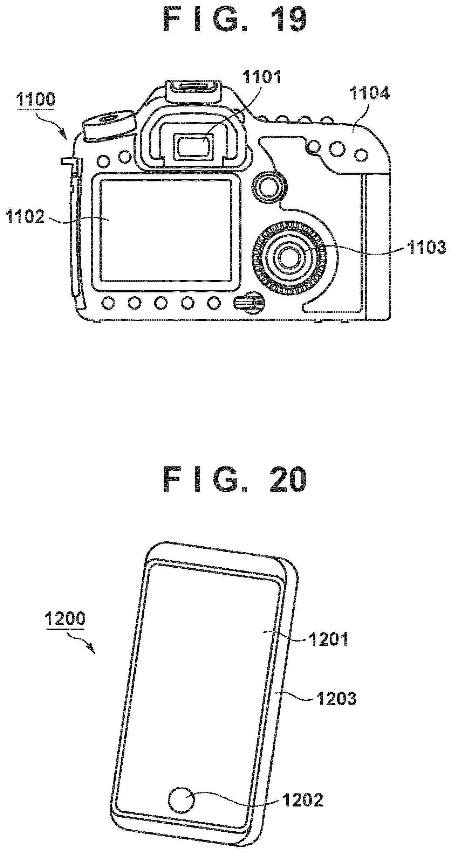

Fig. 19 exemplarily shows the configuration of an image sensing device 1100 in which the display device according to each of the above-described embodiments is incorporated. The image sensing device 1100 can include a viewfinder 1101, a rear display 1102, an operation unit 1103, and a housing 1104. The image sensing device may also be called a camera. Alternatively, the image sensing device may be incorporated in an electronic apparatus such as a computer. The display device according to each of the above-described embodiments can be applied to the viewfinder 1101 as a display unit. Not only an image captured by an image sensor but also environment information, image sensing instructions, and the like may be displayed on the viewfinder 1101. Examples of the environment information are the intensity and direction of external light, the moving velocity of an object, and the possibility that an object is covered with an obstacle.

The image sensing device 1100 includes an optical unit (not shown). This optical unit has a plurality of lenses, and forms an image on an image sensor (not shown) that receives light having passed through the optical unit and is accommodated in the housing 1104. The focal points of the plurality of lenses can be adjusted by adjusting the relative positions. This operation can also automatically be performed.

The display device according to each of the above-described embodiments may be applied to a display unit of an electronic apparatus. At this time, the display unit can have both a display function and an operation function. Examples of the portable terminal are a portable phone such as a smartphone, a tablet, and a head mounted display.

Fig. 20 is a schematic view showing an example of an electronic apparatus in which the display device according to each of the above-described embodiments is incorporated. An electronic apparatus 1200 includes a display unit 1201, an operation unit 1202, and a housing 1203. The housing 1203 can accommodate a circuit, a printed board having this circuit, a battery, and a communication unit. The operation unit 1202 can be a button or a touch-panel-type reaction unit. The operation unit 1202 can also be a biometric authentication unit that performs unlocking or the like by authenticating the fingerprint. The portable apparatus including the communication unit can also be regarded as a communication apparatus. The display device according to each of the above-described embodiments can be applied to the display unit 1201.

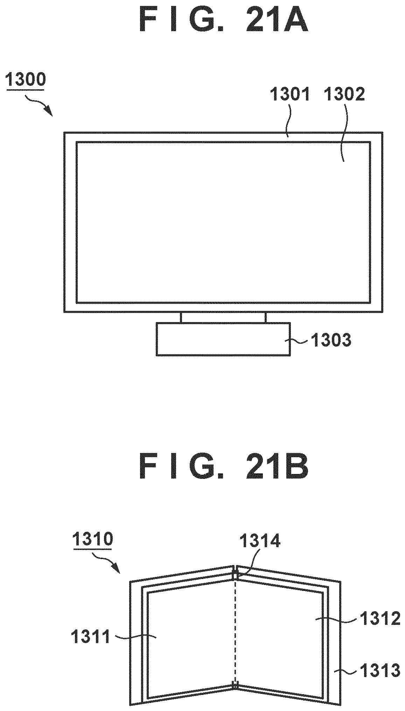

Figs. 21A and 21B show application examples of the display device according to each of the above-described embodiments. Fig. 21A shows a display device such as a television monitor or a PC monitor. A display device 1300 includes a frame 1301 and a display unit 1302. The display device according to each of the above-described embodiments can be applied to the display unit 1302. The display device 1300 can include a base 1303 that supports the frame 1301 and the display unit 1302. The base 1303 is not limited to the form shown in Fig. 21A. For example, the lower side of the frame 1301 may also function as the base 1303. In addition, the frame 1301 and the display unit 1302 can be bent. The radius of curvature in this case can be 5,000 mm (inclusive) to 6,000 mm (inclusive).

Fig. 21B shows another application example of the display device according to each of the above-described embodiments. A display device 1310 shown in Fig. 21B can be folded, and is a so-called foldable display device. The display device 1310 includes a first display unit 1311, a second display unit 1312, a housing 1313, and a bending point 1314. The display device according to each of the above-described embodiments can be applied to each of the first display unit 1311 and the second display unit 1312. The first display unit 1311 and the second display unit 1312 can also be one seamless display device. The first display unit 1311 and the second display unit 1312 can be divided by the bending point. The first display unit 1311 and the second display unit 1312 can display different images, and can also display one image together.

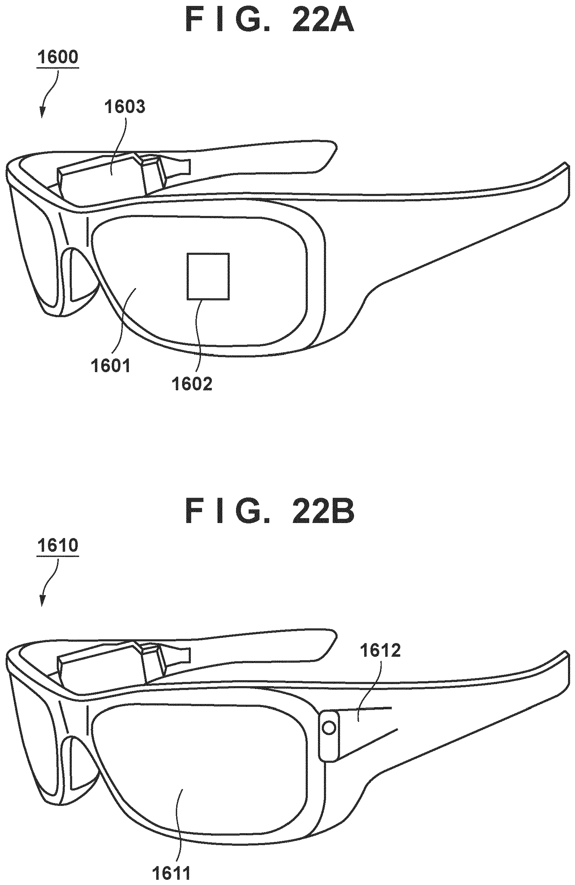

Figs. 22A and 22B show other examples of the electronic apparatus in which the display device according to each of the above-described embodiments is incorporated. The display device according to each of the above-described embodiments can be applied to a wearable device such as smartglasses, an HMD, or a smart contact lens. An image sensing display device used for such application examples includes an image sensing device capable of photoelectrically converting visible light and a display device capable of emitting visible light.

Glasses 1600 (smartglasses) according to one application example will be described with reference to Fig. 22A. An image sensing device 1602 such as a CMOS sensor or an SPAD is provided on the surface side of a lens 1601 of the glasses 1600. In addition, the display device according to each of the above-described embodiments is provided on the back surface side of the lens 1601.

The glasses 1600 further include a control device 1603. The control device 1603 functions as a power supply that supplies electric power to the image sensing device 1602 and the display device according to each of the above-described embodiments. In addition, the control device 1603 controls the operations of the image sensing device 1602 and the display device. An optical system configured to condense light to the image sensing device 1602 is formed on the lens 1601.

Glasses 1610 (smartglasses) according to one application example will be described with reference to Fig. 22B. The glasses 1610 include a control device 1612, and an image sensing device corresponding to the image sensing device 1602 and the display device are mounted on the control device 1612. The image sensing device in the control device 1612 and an optical system configured to project light emitted from the display device are formed in a lens 1611, and an image is projected to the lens 1611. The control device 1612 functions as a power supply that supplies electric power to the image sensing device and the display device, and controls the operations of the image sensing device and the display device. The control device may include a line-of-sight detection unit that detects the line of sight of a wearer. The detection of a line of sight may be done using infrared rays. An infrared ray emitting unit emits infrared rays to an eyeball of the user who is gazing at a displayed image. An image sensing unit including a light receiving element detects reflected light of the emitted infrared rays from the eyeball, thereby obtaining a captured image of the eyeball. A reduction unit for reducing light from the infrared ray emitting unit to the display unit in a planar view is provided, thereby reducing deterioration of image quality.

The line of sight of the user to the displayed image is detected from the captured image of the eyeball obtained by sensing the infrared rays. An arbitrary known method can be applied to the line-of-sight detection using the captured image of the eyeball. As an example, a line-of-sight detection method based on a Purkinje image obtained by reflection of irradiation light by a cornea can be used.

More specifically, line-of-sight detection processing based on pupil center corneal reflection is performed. Using pupil center corneal reflection, a line-of-sight vector representing the direction (rotation angle) of the eyeball is calculated based on the image of the pupil and the Purkinje image included in the captured image of the eyeball, thereby detecting the line-of-sight of the user.

The display device according to the embodiment of the present invention can include an image sensing device including a light receiving element, and control a displayed image of the display device based on the line-of-sight information of the user from the image sensing device.

More specifically, the display device decides a first visual field region at which the user is gazing and a second visual field region other than the first visual field region based on the line-of-sight information. The first visual field region and the second visual field region may be decided by the control device of the display device, or those decided by an external control device may be received. In the display region of the display device, the display resolution of the first visual field region may be controlled to be higher than the display resolution of the second visual field region. That is, the resolution of the second visual field region may be lower than that of the first visual field region.

In addition, the display region includes a first display region and a second display region different from the first display region, and a region of higher priority is decided from the first display region and the second display region based on line-of-sight information. The first visual field region and the second visual field region may be decided by the control device of the display device, or those decided by an external control device may be received. The resolution of the region of higher priority may be controlled to be higher than the resolution of the region other than the region of higher priority. That is, the resolution of the region of relatively low priority may be low.

Note that AI may be used to decide the first visual field region or the region of higher priority. The AI may be a model configured to estimate the angle of the line of sight and the distance to a target ahead the line of sight from the image of the eyeball using the image of the eyeball and the direction of actual viewing of the eyeball in the image as supervised data. The AI program may be held by the display device, the image sensing device, or an external device. If the external device holds the AI program, it is transmitted to the display device via communication.

When performing display control based on line-of-sight detection, smartglasses further including an image sensing device configured to sense the image of the outside can preferably be applied. The smartglasses can display the sensed outside image information in real time.

As described above, when a device using the organic light-emitting element according to this embodiment is used, it is possible to perform stable display with high image quality for a long time.

The present invention is not limited to the above embodiments and various changes and modifications can be made within the spirit and scope of the present invention. Therefore, to apprise the public of the scope of the present invention, the following claims are made.

This application claims priority from Japanese Patent Application No. 2021-119008 filed July 19, 2021, which is hereby incorporated by reference herein.

REFERENCE SIGNS LIST

LEDA: light-emitting element array, CFL: color filter layer, MLL: microlens layer

**Claims**

1. A display device comprising:

   a light-emitting element array including a plurality of light-emitting elements arranged on a substrate; and
   a color filter layer arranged on the light-emitting element array and including a plurality of first bandpass filters configured to transmit light in a first band, a plurality of second bandpass filters configured to transmit light in a second band different from the first band, and a plurality of third bandpass filters configured to transmit light in a third band different from the first band and the second band,
   wherein the color filter layer has an arrangement including at least a first column in which the first bandpass filters are arranged, a second column in which the second bandpass filters and the third bandpass filters are alternately arranged, and a third column in which the second bandpass filters and the third bandpass filters are alternately arranged in an order different from the second column, and
   at least one first bandpass filter is in contact with at least one second bandpass filter and at least one third bandpass filter.

2. A display device comprising:

   a light-emitting element array including a plurality of light-emitting elements arranged on a substrate; and
   a color filter layer arranged on the light-emitting element array and including a plurality of first bandpass filters configured to transmit light in a first band, a plurality of second bandpass filters configured to transmit light in a second band different from the first band, and a plurality of third bandpass filters configured to transmit light in a third band different from the first band and the second band,
   wherein the color filter layer has an arrangement in which the first bandpass filters are arranged in accordance with a delta arrangement, and the number of second bandpass filters and third bandpass filters is smaller than the number of first bandpass filters, and
   at least one first bandpass filter is in contact with at least one second bandpass filter and at least one third bandpass filter.

3. The display device according to claim 1 or 2, wherein
   if areas occupied, in a unit pixel region, by bandpass filters with the largest number of pieces, bandpass filters with the second largest number of pieces, and bandpass filters with the third largest number of pieces among the first bandpass filters, the second bandpass filters, and the third bandpass filters are defined as A, B, and C, respectively,

$$A/B < 2 \cdot C/B$$

   is satisfied.

4. The display device according to claim 3, wherein

$$A/B < 1.5 \cdot C/B$$

   is satisfied.

5. The display device according to claim 3, wherein

$$A/B < 1.2 \cdot C/B$$

is satisfied.

6. The display device according to claim 3, wherein
   B and C each have a value less than $\pm 5\%$ of A.

7. The display device according to any one of claims 1 to 6, wherein
   if the bandpass filters with the largest number of pieces among the first bandpass filters, the second bandpass filters, and the third bandpass filters are defined as main bandpass filters, a region surrounded by perpendicular bisectors between one main bandpass filter and respective main bandpass filters around the one main bandpass filter is the unit pixel region including the one main bandpass filter.

8. The display device according to claim 1 or 2, wherein
   if total areas occupied, in a unit pixel region, by bandpass filters with the largest number of pieces, bandpass filters with the second largest number of pieces, and bandpass filters with the third largest number of pieces among the first bandpass filters, the second bandpass filters, and the third bandpass filters are defined as TA, TB, and TC, respectively,

$$TA/TB \leq 2 \cdot TC/TB$$

is satisfied.

9. The display device according to claim 8, wherein

$$TA/TB < 1.5 \cdot TC/TB$$

is satisfied.

10. The display device according to claim 8, wherein

$$TA/TB < 1.2 \cdot TC/TB$$

is satisfied.

11. The display device according to claim 8, wherein
    TB and TC each have a value less than $\pm 5\%$ of TA.

12. The display device according to any one of claims 1 to 11, further comprising
    a microlens array including a plurality of microlenses arranged on the color filter layer.

13. The display device according to any one of claims 1 to 11, further comprising

    a microlens array including a plurality of microlenses arranged on the color filter layer,
    wherein the plurality of microlenses are arranged such that one microlens is assigned to each of the plurality of first bandpass filters, the plurality of second bandpass filters, and the plurality of third bandpass filters.

14. The display device according to any one of claims 1 to 11, further comprising

    a microlens array including a plurality of microlenses arranged on the color filter layer,
    wherein the plurality of microlenses include a first microlens assigned to each bandpass filter of one group among a first group formed by the plurality of first bandpass filters, a second group formed by the plurality of second bandpass filters, and a third group formed by the plurality of third bandpass filters, and a second microlens assigned to each bandpass filter of remaining two groups among the first group, the second group, and the third group, and

a bottom surface size of the first microlens is smaller than a bottom surface size of the second microlens.

15. The display device according to claim 14, wherein
in an orthographic projection to the light-emitting element array, one first microlens is arranged in contact with four second microlenses that are arranged not in contact with each other.

16. The display device according to claim 14, wherein
in an orthographic projection to the light-emitting element array, one first microlens is arranged in contact with four second microlenses that are arranged in contact with each other.

17. The display device according to any one of claims 14 to 16, wherein
a radius of curvature of a lens surface of the first microlens is smaller than a radius of curvature of a lens surface of the second microlens.

18. The display device according to any one of claims 14 to 16, wherein
a radius of curvature of a lens surface of the first microlens is less than ±20%, less than ±10%, or less than ±5% of a radius of curvature of a lens surface of the second microlens.

19. The display device according to claim 12 or 13, wherein
in an orthographic projection to the light-emitting element array, a maximum value of a bottom surface size, a height, or a radius of curvature of the plurality of microlenses is less than 1.2 times, 1.1 times, or 1.05 times a minimum value.

20. The display device according to any one of claims 1 to 11, further comprising

a microlens array including a plurality of microlenses arranged on the color filter layer,
wherein at least two microlenses of the plurality of microlenses are assigned to each bandpass filter of two groups among a first group formed by the plurality of first bandpass filters, a second group formed by the plurality of second bandpass filters, and a third group formed by the plurality of third bandpass filters.

21. The display device according to any one of claims 1 to 11, further comprising

a microlens array including a plurality of microlenses arranged on the color filter layer,
wherein three microlenses of the plurality of microlenses are assigned to each bandpass filter of two groups among a first group formed by the plurality of first bandpass filters, a second group formed by the plurality of second bandpass filters, and a third group formed by the plurality of third bandpass filters.

22. The display device according to any one of claims 1 to 11, further comprising

a microlens array including a plurality of microlenses arranged on the color filter layer,
wherein one microlens of the plurality of microlenses is assigned to each bandpass filter of one group among a first group formed by the plurality of first bandpass filters, a second group formed by the plurality of second bandpass filters, and a third group formed by the plurality of third bandpass filters, two microlenses of the plurality of microlenses are assigned to each bandpass filter of another group among the first group, the second group, and the third group, and four microlenses of the plurality of microlenses are assigned to each bandpass filter of still another group among the first group, the second group, and the third group.

23. The display device according to any one of claims 1 to 11, further comprising

a microlens array including a plurality of microlenses arranged on the color filter layer,
wherein one microlens of the plurality of microlenses is assigned to each bandpass filter of one group among a first group formed by the plurality of first bandpass filters, a second group formed by the plurality of second bandpass filters, and a third group formed by the plurality of third bandpass filters, and two microlenses of the plurality of microlenses are assigned to each bandpass filter of remaining two groups among the first group, the second group, and the third group.

**24.** The display device according to any one of claims 1 to 11, further comprising

a microlens array including a plurality of microlenses arranged on the color filter layer, wherein one microlens of the plurality of microlenses is assigned to each bandpass filter of one group among a first group formed by the plurality of first bandpass filters, a second group formed by the plurality of second bandpass filters, and a third group formed by the plurality of third bandpass filters, and not less than 10 microlenses of the plurality of microlenses are assigned to each bandpass filter of remaining two groups among the first group, the second group, and the third group.

**25.** The display device according to claim 16, wherein each of the plurality of light-emitting elements is provided with openings as many as the microlenses assigned to a corresponding bandpass filter.

**26.** The display device according to claim 1 or 2, wherein

the plurality of first bandpass filters each have a square shape and are arranged apart from each other in a square grating pattern, and the plurality of second bandpass filters and the plurality of third bandpass filters each have an octagonal shape formed by four sets of parallel opposite sides, two second bandpass filters are in line contact with one set of opposite sides of the square of the first bandpass filter, and two third bandpass filters are in line contact with the other set of opposite sides of the square of the first bandpass filter, and two sets of opposite sides among the four sets of opposite sides of the second bandpass filter, which are not in contact with the first bandpass filters, are in line contact with two sets of opposite sides among the four sets of opposite sides of the third bandpass filters, which are not in contact with the first bandpass filters.

**27.** The display device according to claim 26, wherein

a length of the two sets of opposite sides among the four sets of opposite sides of the second bandpass filter, which are not in contact with the first bandpass filters, is shorter than a length of the two sets of opposite sides among the four sets of opposite sides of the second bandpass filter, which are in line contact with the first bandpass filters, a length of the two sets of opposite sides among the four sets of opposite sides of the third bandpass filter, which are not in contact with the first bandpass filters, is shorter than a length of the two sets of opposite sides among the four sets of opposite sides of the third bandpass filter, which are in line contact with the first bandpass filters.

**28.** The display device according to claim 26, wherein

a length of the two sets of opposite sides among the four sets of opposite sides of the second bandpass filter, which are not in contact with the first bandpass filters, is not less than a length of the two sets of opposite sides among the four sets of opposite sides of the second bandpass filter, which are in line contact with the first bandpass filters, a length of the two sets of opposite sides among the four sets of opposite sides of the third bandpass filter, which are not in contact with the first bandpass filters, is not less than a length of the two sets of opposite sides among the four sets of opposite sides of the third bandpass filter, which are in line contact with the first bandpass filters.

**29.** The display device according to claim 1 or 2, wherein the first bandpass filter, the second bandpass filter, and the third bandpass filter have the same shape.

**30.** The display device according to claim 29, wherein the first bandpass filter, the second bandpass filter, and the third bandpass filter each have a square shape.

**31.** The display device according to any one of claims 26 to 30, further comprising

a microlens array including a plurality of microlenses arranged on the color filter layer, wherein the plurality of microlenses are arranged such that one microlens is assigned to each of the plurality of first bandpass filters, the plurality of second bandpass filters, and the plurality of third bandpass filters.

**32.** The display device according to claim 1 or 2, wherein

the first bandpass filter has a hexagonal shape formed by three sets of parallel opposite sides,
the second bandpass filter has a shape obtained by connecting three hexagons each formed by three sets of parallel opposite sides such that the hexagons share two sides adjacent to each other, and
the third bandpass filter has a shape obtained by connecting three hexagons each formed by three sets of parallel opposite sides such that the hexagons share two sides adjacent to each other.

**33.** The display device according to claim 1 or 2, wherein

the first bandpass filter has a hexagonal shape formed by three sets of parallel opposite sides,
the second bandpass filter has a shape obtained by connecting two hexagons each formed by three sets of parallel opposite sides, and
the third bandpass filter has a shape obtained by connecting four hexagons each formed by three sets of parallel opposite sides such that a cross shape is formed.

**34.** The display device according to claim 1 or 2, wherein

the first bandpass filter has a hexagonal shape formed by three sets of parallel opposite sides,
the second bandpass filter has a shape obtained by connecting two hexagons each formed by three sets of parallel opposite sides, and
the third bandpass filter has a shape obtained by connecting two hexagons each formed by three sets of parallel opposite sides.

**35.** The display device according to claim 34, wherein

the first bandpass filter includes a first side, a second side parallel to the first side, a third side connected to the second side, a fourth side that connects the third side and the first side, a fifth side parallel to the fourth side, and a sixth side that connects the fifth side and the first side, and
the first side is in line contact with one side of one second bandpass filter, the second side and the third side are in line contact with two sides of another second bandpass filter, respectively, the fourth side is in line contact with one side of one third bandpass filter, the fifth side and the sixth side are in line contact with two sides of another third bandpass filter.

**36.** The display device according to claim 34, wherein

the first bandpass filter includes a first side, a second side connected to the first side, a third side parallel to the first side, a fourth side parallel to the second side, a fifth side that connects the second side and the third side, and a sixth side that connects the first side and the fourth side, and
the fifth side and the sixth side are each in line contact with one side of a corresponding one of second bandpass filters different from each other, the first side and the second side are in line contact with two sides of one third bandpass filter, respectively, and the third side and the fourth side are in line contact with two sides of another third bandpass filter.

**37.** The display device according to claim 1 or 2, wherein

the first bandpass filter has a hexagonal shape formed by three sets of parallel opposite sides,
the second bandpass filter has a shape obtained by connecting a plurality of hexagons each formed by three sets of parallel opposite sides such that two opposite sides of the light-emitting element array are connected, and
the third bandpass filter has a shape obtained by connecting a plurality of hexagons each formed by three sets of parallel opposite sides such that the two opposite sides of the light-emitting element array are connected.

**38.** The display device according to any one of claims 32 to 37, wherein
the plurality of light-emitting elements are arranged such that one light-emitting element corresponds to one color filter.

**39.** The display device according to any one of claims 32 to 38, further comprising

a microlens array including a plurality of microlenses arranged on the color filter layer,

wherein the plurality of microlenses are arranged such that one microlens is assigned to one hexagon.

40. The display device according to claim 39, wherein
each of the plurality of light-emitting elements is provided with openings as many as the microlenses assigned to a corresponding bandpass filter.

41. The display device according to any one of claims 1 to 40, wherein
the plurality of light-emitting elements generate light components including wavelengths of red, green, and blue.

42. An image sensing device comprising:

an optical unit including a plurality of lenses, an image sensor configured to receive light having passed through the optical unit, and a display unit configured to display an image,
wherein the display unit is a display unit configured to display an image captured by the image sensor and includes a display device defined in any one of claims 1 to 40.

43. An electronic apparatus comprising:

a housing provided with a display unit, and a communication unit provided in the housing and configured to perform external communication,
wherein the display unit includes a display device defined in any one of claims 1 to 40.

F I G. 1A

CFL

PU

A'

CFG,
GSP

CFB,
BSP

CFR,
RSP

A

MLL

F I G. 1B

PU    ML2    ML2

GSP

BSP

RSP

ML2  ML1    ML2

# F I G. 1C

CFG,
GSP

CFB,
BSP

CFR,
RSP

PU

BM

# F I G. 2

PU  OP  PL

CFG,
GSP

CFB,
BSP

CFR,
RSP

# FIG. 3

EP 4 350 399 A1

FIG. 4

CFL

CFR · CFG · CFR · CFG

SF

LEDA

LED

OF

S · SPE · CE

SPE

OP · SPE

SPE

BNK

# F I G. 5A

CFL

L

LED

# FIG. 5B

EP 4 350 399 A1

# FIG. 6A

CFL

PU

CFG,
GSP

CFB,
BSP

CFR,
RSP

# FIG. 6B

MLL

PU   ML2   ML2

GSP

BSP

RSP

ML2   ML1   ML2

# FIG. 7

EP 4 350 399 A1

# F I G. 8A

# F I G. 8B

# FIG. 9A

PU

CFL

CFG,
GSP

CFB,
BSP

CFR,
RSP

# FIG. 9B

MLL

PU

ML

GSP

BSP

RSP

# FIG. 10

OP          PU

CFG,
GSP

CFB,
BSP

CFR,
RSP

# FIG. 11

PU          CFL

CFG,
GSP

CFB,
BSP

CFR,
RSP

# F I G. 12A

CFL

PU

CFG,GSP

CFB,BSP

a    d

f    c

e    b

CFR,RSP

# F I G. 12B

MLL    ML

# FIG. 13

# FIG. 14

# F I G. 15

# FIG. 16

EP 4 350 399 A1

EP 4 350 399 A1

# F I G. 17

# F I G. 18

EP 4 350 399 A1

# F I G. 19

# F I G. 20

## F I G. 21A

## F I G. 21B

# F I G. 22A

1600

1603

1601

1602

# F I G. 22B

1610

1612

1611

# INTERNATIONAL SEARCH REPORT

International application No.

**PCT/JP2022/023503**

### A. CLASSIFICATION OF SUBJECT MATTER

*G02B 5/20*(2006.01)i; *G02B 3/00*(2006.01)i; *G09F 9/30*(2006.01)i; *G09F 9/302*(2006.01)i; *H01L 27/146*(2006.01)i;
*H01L 27/32*(2006.01)i; *H01L 51/50*(2006.01)i; *H05B 33/02*(2006.01)i; *H05B 33/12*(2006.01)i
FI:   G02B5/20 101; H05B33/14 A; H01L27/32; H05B33/12 E; H05B33/12 B; H05B33/02; G02B3/00 A; G09F9/30 349B;
G09F9/302 C; G09F9/30 365; H01L27/146 D

According to International Patent Classification (IPC) or to both national classification and IPC

### B. FIELDS SEARCHED

Minimum documentation searched (classification system followed by classification symbols)

G02B5/20; G02B3/00; G09F9/30; G09F9/302; H01L27/146; H01L27/32; H01L51/50; H05B33/02; H05B33/12

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | US 2016/0365397 A1 (SAMSUNG DISPLAY CO., LTD.) 15 December 2016 (2016-12-15) paragraphs [0080]-[0094], fig. 3-5B | 1, 3-11, 26-30, 41 |
| Y | paragraphs [0080]-[0094], fig. 3-5B | 12-20, 24-25, 31, 42-43 |
| A | | 2, 21-23, 32-40 |
| Y | US 2020/0119113 A1 (SAMSUNG DISPLAY CO., LTD.) 16 April 2020 (2020-04-16) paragraphs [0118]-[0126], [0141], fig. 6-8 | 12-20, 24-25, 31, 42-43 |
| Y | JP 2020-184477 A (SEIKO EPSON CORP) 12 November 2020 (2020-11-12) paragraphs [0072], [0089], fig. 12, 18-19 | 15-16, 20, 24-25, 42-43 |
| Y | JP 2020-184478 A (SEIKO EPSON CORP) 12 November 2020 (2020-11-12) paragraphs [0087], [0110], fig. 14, 22-23 | 15-16, 20, 24-25, 42-43 |
| Y | WO 2017/018041 A1 (SONY CORP) 02 February 2017 (2017-02-02) paragraphs [0047], [0070], fig. 1 | 20, 24, 42-43 |

☑ Further documents are listed in the continuation of Box C.    ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **19 August 2022** | **30 August 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

## INTERNATIONAL SEARCH REPORT

International application No.

**PCT/JP2022/023503**

**C.** **DOCUMENTS CONSIDERED TO BE RELEVANT**

| Category* | Citation of document, with indication, where appropriate, of the relevant passages | Relevant to claim No. |
|---|---|---|
| Y | JP 2020-201484 A (SEMICONDUCTOR ENERGY LAB CO LTD) 17 December 2020 (2020-12-17) paragraphs [0086], [0541], fig. 1(A) | 20, 24, 42-43 |
| A | JP 2021-72285 A (SAMSUNG DISPLAY CO., LTD.) 06 May 2021 (2021-05-06) entire text, all drawings | 1-43 |

Form PCT/ISA/210 (second sheet) (January 2015)

**INTERNATIONAL SEARCH REPORT**
Information on patent family members

International application No.

**PCT/JP2022/023503**

| Patent document cited in search report | | | Publication date (day/month/year) | Patent family member(s) | | | Publication date (day/month/year) |
|---|---|---|---|---|---|---|---|
| US | 2016/0365397 | A1 | 15 December 2016 | KR | 10-2016-0148113 | A | |
| US | 2020/0119113 | A1 | 16 April 2020 | KR | 10-2020-0042981 | A | |
| | | | | CN | 111063706 | A | |
| JP | 2020-184477 | A | 12 November 2020 | US | 2020/0358035 | A1 | |
| | | | | paragraphs [0100], [0117], fig. 12, 18-19 | | | |
| JP | 2020-184478 | A | 12 November 2020 | US | 2020/0357854 | A1 | |
| | | | | paragraphs [0117], [0141], fig. 14, 22-23 | | | |
| | | | | CN | 111916480 | A | |
| WO | 2017/018041 | A1 | 02 February 2017 | US | 2020/0058888 | A1 | |
| | | | | paragraphs [0068], [0095], fig. 1 | | | |
| | | | | JP | 2017-27872 | A | |
| | | | | CN | 107852787 | A | |
| JP | 2020-201484 | A | 17 December 2020 | US | 2020/0388790 | A1 | |
| | | | | paragraphs [0116], [0571], fig. 1A | | | |
| | | | | CN | 112054040 | A | |
| | | | | KR | 10-2020-0140206 | A | |
| | | | | TW | 202114262 | A | |
| JP | 2021-72285 | A | 06 May 2021 | US | 2021/0126065 | A1 | |
| | | | | entire text, all drawings | | | |
| | | | | EP | 3817062 | A2 | |
| | | | | KR | 10-2021-0052650 | A | |
| | | | | CN | 112750872 | A | |

Form PCT/ISA/210 (patent family annex) (January 2015)

EP 4 350 399 A1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2020205260 A

- JP 2021119008 A